(19) Europäisches Patentamt
European Patent Office
Office européen des brevets

(11) **EP 3 331 163 B1**

(12) **EUROPEAN PATENT SPECIFICATION**

(45) Date of publication and mention
of the grant of the patent:
**11.09.2019 Bulletin 2019/37**

(51) Int Cl.:
**H03J 3/26** (2006.01)

(21) Application number: **17203046.2**

(22) Date of filing: **22.11.2017**

(54) **METHOD OF ELECTRICAL BALANCING IN A THREE-PHASE SYSTEM**

VERFAHREN ZUM ELEKTRISCHEN AUSGLEICH IN EINEM DREIPHASIGEN SYSTEM

PROCÉDÉ D'ÉQUILIBRAGE ÉLECTRIQUE DANS UN SYSTÈME TRIPHASÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.11.2016 ES 201631532**

(43) Date of publication of application:
**06.06.2018 Bulletin 2018/23**

(73) Proprietor: **Power Electronics España, S.L.
46980 Paterna / Valencia (ES)**

(72) Inventors:
• **SALVO LILLO, David
  46980 PATERNA (Valencia) (ES)**
• **SALVO LILLO, Abelardo
  46980 PATERNA (Valencia) (ES)**
• **POVEDA LERMA, Antonio
  46980 PATERNA (Valencia) (ES)**
• **CAMPS SORIANO, José Luis
  46980 PATERNA (Valencia) (ES)**
• **ANTÓN PONS, Marcial
  46980 PATERNA (Valencia) (ES)**

(74) Representative: **Ungria López, Javier
  Avda. Ramón y Cajal, 78
  28043 Madrid (ES)**

(56) References cited:
**WO-A2-2009/148555      US-A- 5 986 909
US-A1- 2013 051 498**

**EP 3 331 163 B1**

**Description**

**FIELD OF THE INVENTION**

The present invention relates to a method of electrical balancing applicable to three-phase systems.

The technical field of the invention pertains to the field of converters, generators, transformers, motors and any other type of power system where there is three-phase voltage/current.

**BACKGROUND OF THE INVENTION**

An n-phase (or polyphase) power converter based on the Multilevel Cascaded H-Bridge (MCHB) topology can be represented as a set of single-phase sinusoidal voltage generators in series. In other words, a three-phase power converter has three single-phase power generators, where each power generator is made up of several power-generating cells connected in series. In this way, and under ideal conditions, three voltages of the same magnitude and separated by 120° are obtained at the output of the converter.

In the previous situation, it may be possible that a cell enters failure mode, and therefore, the cell ceases to generate power. This means that the single-phase generator containing said cell ceases to produce power, thus leading to a failure in the converter.

In the state of the art, the aforementioned problem, in other words, when the cell fails, is resolved by short-circuiting the power cell. In other words, a "bypass" of the failed cell is carried out. This is carried out by means of a control system located in such a way that each of the power cells measures the voltage of the cell at the output thereof and detects any fluctuation in the voltage thereof with respect to the normal operating voltage thereof.

The solution of the prior art makes the power converter to continue generating power in the case of failure of at least any one of the cells thereof, but introduces a voltage unbalance in the converter output.

To solve the aforementioned problem of balance, the patent application with publication number US-A1-5,986,909 and title *"Multiphase power supply with plural series connected cells and failed cell bypass"* discloses a static solution based on measuring the output power of the cells and, in the case of failure of one of them, short-circuiting the cell and decreasing the power of the remaining single-phase generators until the power modules at the output are made equal. The balance of the phases is carried out according to previously defined tables.

The solution provided by the previous document has several drawbacks. The first drawback is that the balance is achieved in a static way, in other words, based on pre-defined tables which may not, under any circumstances, include all cases of failure for all possible powers that the cells can generate.

Another drawback is the fact that once a cell is canceled, the number of available PWM (Pulse-Width Modulation) voltage levels decreases, such that the output voltage ripple is greater in the phase affected by the failure. This leads to a greater imbalance than what would have been if the voltages generated in the cells were perfectly sinusoidal instead of being PWM.

Another drawback results from the fact that the multi-output transformers and in particular, the multi-pulse transformers, due to their own physical design, do not have equal impedance in each of the outputs thereof, such that, depending on the load, and even with a full load, the voltages available in each cell are different and a perfectly balanced voltage cannot be generated in the phases of the converter.

Therefore, it would be desirable to obtain a method for balancing the polyphase systems that overcomes the problems of the art mentioned and where balancing is dynamic.

**DESCRIPTION OF THE INVENTION**

In one aspect of the invention, a method of electrical balancing in a three-phase system is disclosed, where the method comprises the following steps:

i) obtaining the magnitude and phase of each line-to-neutral output voltage (R,S,T) of the three-phase system forming a line-to-neutral voltage system ($U_R$, $U_S$, $U_T$); (if the magnitudes and phases of the three voltages are not equal, the method will continue, because if they were equal, the system would be balanced)

ii) aligning a first line-to-neutral voltage with the real axis ($U_R$);

iii) choosing the first line-to-neutral voltage ($U_R$) previously aligned with the real axis and a second line-to-neutral voltage ($U_S$) selected from between the two remaining line-to-neutral voltages ($U_S$, $U_T$); and, adding a third line-to-neutral voltage ($U_S^*$) that is the complex conjugate of the greater ($U_S$) of the two previous voltages ($U_S$, $U_T$);

iv) calculating the positive sequence voltage ($U_D$), the negative sequence voltage ($U_I$) and the zero sequence voltage ($U_H$) of the line-to-neutral voltage system formed by the first line-to-neutral voltage, the second line-to-neutral voltage and the third line-to-neutral voltage ($U_R$, $U_S$, $U_S^*$);

v) adding the negative value of the negative sequence voltage ($-U_I$) with respect to the previously calculated negative sequence voltage ($U_I$), by means of rotation at an angle "a" of the phase of the second line-to-neutral voltage ($U_S$) and by means of rotation in the direction opposite to the previous direction of the phase of the third line-to-neutral voltage ($U_S{}^*$); thus obtaining a new line-to-neutral voltage system ($U_R$, $U_S$', $U_S{}^*$') (balanced in line-to-neutral voltages and line-to-line voltages) formed by the first line-to-neutral voltage ($U_R$), a new second line-to-neutral voltage ($U_S$') equal in module to the second line-to-neutral voltage ($U_S$) but separated by an angle "a" and a new third line-to-neutral voltage ($U_S{}^*$') equal in module to the third line-to-neutral voltage but counter-separated by a phase angle "$\alpha$";

vi) calculating the positive sequence voltage ($U_D$') and the zero sequence voltage ($U_H$') of the new line-to-neutral voltage system ($U_R$, $U_S$', $U_S{}^*$');

vii) adding the positive sequence voltage (SD) and zero sequence voltage (SH), respectively, to the positive sequence voltage ($U_D$') and to the zero sequence voltage ($U_H$') previously calculated by rotating the first line-to-neutral voltage ($U_R$) by an angle "$\beta$" and rotating the new second line-to-neutral voltage ($U_S$') by the same angle "$\beta$" in the opposite direction; thus obtaining a new positive sequence voltage ($U_D$") and a new zero sequence voltage ($U_H$");

viii) calculating the new line-to-neutral voltages ($U_R$", $U_S$", $U_T$") from the new positive sequence voltage ($U_D$") and the new zero sequence voltage ($U_H$"), with negative sequence voltage equal to zero (this is because the system is balanced and therefore, it does not have negative sequence voltage);

ix) repeating steps vii) and viii) until the module of the new third line-to-neutral voltage ($U_T$") is equal to the module of the line-to-neutral output voltage discarded in step iii) ($U_T$); where the value of the angle "$\beta$" is modified in each iteration as a function of the difference between the modules of the previous voltages ($|U_T$"$|$ - $|U_T|$).

In one embodiment of the first aspect of the invention, the positive sequence voltage ($U_D$), the negative sequence voltage ($U_I$) and the zero sequence voltage ($U_H$) of a line-to-neutral voltage system ($U_R$, $U_S$, $U_T$) are calculated in the following way:

- $$U_D = \frac{1}{3}(U_R + U_S a + U_T a^2)$$

- $$U_I = \frac{1}{3}(U_R + U_S a^2 + U_T a)$$

- $$U_H = \frac{1}{3}(U_R + U_S + U_T)$$

where $a = e^{j\frac{2\pi}{3}}$.

In another embodiment of the first aspect of the invention, the first line-to-neutral voltage ($U_R$), the new second line-to-neutral voltage ($U_S$'), the new third line-to-neutral voltage ($U_S{}^*$') and the angle "$\alpha$" are related as follows:

$$(U_s' \cos(\alpha) + U_R)\tan\left(\frac{\pi}{6}\right) = U_s' \sin(\alpha)$$

$$U_s^{*\prime} = conj(U_s')$$

In another embodiment of the first aspect of the invention, a first line-to-neutral voltage ($U_R$), a second line-to-neutral voltage ($U_S$) and a third line-to-neutral voltage ($U_T$) are obtained from positive sequence voltages ($U_D$), negative sequence voltages ($U_I$) and zero sequence voltages ($U_H$):

$$\begin{bmatrix} U_R \\ U_S \\ U_T \end{bmatrix} = \begin{bmatrix} 1 & 1 & 1 \\ a^2 & a & 1 \\ a & a^2 & 1 \end{bmatrix} \begin{bmatrix} U_D \\ U_I \\ U_H \end{bmatrix}$$

where $a = e^{j\frac{2\pi}{3}}$.

In another embodiment of the first aspect of the invention, the positive sequence voltage (SD) and the zero sequence voltage (SH) that are added in step vii) are calculated in the following way:

$$U_R + SD_R + SH_R = U_R''$$

$$U_S' + SD_S + SH_S = U_S''$$

where:

$$SD_R = SD_{RX} + jSD_{RY}$$

$$SH_R = SH_S = SH = SH_X + jSH_Y$$

and,

$$
\begin{pmatrix} SD_{RX} \\ SD_{RY} \\ SH_X \\ SH_Y \end{pmatrix} =
\begin{pmatrix}
1 & 0 & 1 & 0 \\
0 & 1 & 0 & 1 \\
\cos\left(\frac{4\pi}{3}\right) & \sin\left(\frac{4\pi}{3}\right) & 1 & 0 \\
-\sin\left(\frac{4\pi}{3}\right) & \cos\left(\frac{4\pi}{3}\right) & 0 & 1
\end{pmatrix}^{-1}
\begin{pmatrix}
-1 & 0 & 0 & 0 & 1 & 0 & 0 & 0 \\
0 & -1 & 0 & 0 & 0 & 1 & 0 & 0 \\
0 & 0 & -1 & 0 & 0 & 0 & 1 & 0 \\
0 & 0 & 0 & -1 & 0 & 0 & 0 & 1
\end{pmatrix}
\begin{pmatrix}
real(U_R) \\
imag(U_R) \\
real(U_S') \\
imag(U_S') \\
real(U_R'') \\
imag(U_R'') \\
real(U_S'') \\
imag(U_S'')
\end{pmatrix}
$$

where

$$
\begin{pmatrix}
1 & 0 & 1 & 0 \\
0 & 1 & 0 & 1 \\
\cos\left(\frac{4\pi}{3}\right) & \sin\left(\frac{4\pi}{3}\right) & 1 & 0 \\
-\sin\left(\frac{4\pi}{3}\right) & \cos\left(\frac{4\pi}{3}\right) & 0 & 1
\end{pmatrix}^{-1} =
\begin{pmatrix}
-\cos\left(\frac{4\pi}{3}\right) & -\frac{1}{3}\sin\left(\frac{4\pi}{3}\right) & \cos\left(\frac{4\pi}{3}\right) & \frac{1}{3}\sin\left(\frac{4\pi}{3}\right) \\
\frac{1}{3}\sin\left(\frac{4\pi}{3}\right) & -\cos\left(\frac{4\pi}{3}\right) & -\frac{1}{3}\sin\left(\frac{4\pi}{3}\right) & \cos\left(\frac{4\pi}{3}\right) \\
-\cos\left(\frac{4\pi}{3}\right) & \frac{1}{3}\sin\left(\frac{4\pi}{3}\right) & -\cos\left(\frac{4\pi}{3}\right) & -\frac{1}{3}\sin\left(\frac{4\pi}{3}\right) \\
-\frac{1}{3}\sin\left(\frac{4\pi}{3}\right) & -\cos\left(\frac{4\pi}{3}\right) & \frac{1}{3}\sin\left(\frac{4\pi}{3}\right) & -\cos\left(\frac{4\pi}{3}\right)
\end{pmatrix}
$$

In another embodiment of the first aspect of the invention, the method further comprises calculating line-to-line voltages ($U_{RS}$, $U_{ST}$, $U_{TR}$) from the line-to-neutral voltages ($U_R$, $U_S$, $U_T$) by means of subtracting the two line-to-neutral voltages:

$$U_{RS} = U_S - U_R;$$

$$U_{ST} = U_T - U_S;$$

$$U_{TR} = U_R - U_T;$$

In another embodiment of the first aspect of the invention, the method further comprises calculating line-to-neutral voltages ($U_R$, $U_S$, $U_T$) from the line-to-line voltages ($U_{RS}$, $U_{ST}$, $U_{TR}$) by means of the following sub-steps:

- calculating the line-to-line voltage system ($U_{CD}$, $U_{CI}$, $U_{CH}$) formed by the positive sequence line-to-line voltage ($U_{CD}$), the negative sequence line-to-line voltage ($U_{CI}$) and the zero sequence line-to-line voltage ($U_{CH}$), associated with the line-to-line voltages ($U_{RS}$, $U_{ST}$, $U_{TR}$):

$$
\begin{bmatrix} U_{CD} \\ U_{CI} \\ U_{CH} \end{bmatrix} = \frac{1}{3}
\begin{bmatrix} 1 & a & a^2 \\ 1 & a^2 & a \\ 1 & 1 & 1 \end{bmatrix}
\begin{bmatrix} U_{RS} \\ U_{ST} \\ U_{TR} \end{bmatrix}
$$

○ where $a = e^{j\frac{2\pi}{3}}$

- calculating the angle "a" of the positive sequence and subtract $\pi/6$:

$$\alpha = angle(U_{CD}) - \frac{\pi}{6}$$

○ where:

$$angle(U_{CD}) = atan2\left(\frac{imag(U_{CD})}{real(U_{CD})}\right)$$

- rotating in a counterclockwise direction the system formed by the line-to-line voltages by the angle $\alpha$ calculated above:

○ $U'_{RS} = |U_{RS}|e^{j[angle(U_{RS})-\alpha]}$

○ $U'_{ST} = |U_{ST}|e^{j[angle(U_{ST})-\alpha]}$

○ $U'_{TR} = |U_{TR}|e^{j[angle(U_{TR})-\alpha]}$

- calculating the positive sequence line-to-line voltage (U'$_{CD}$), the negative sequence line-to-line voltage (U'$_{CI}$) and the zero sequence line-to-line voltage (U'$_{CI}$) of the rotated line-to-line voltage system:

$$\begin{bmatrix} U'_{CD} \\ U'_{CI} \\ U'_{CH} \end{bmatrix} = \frac{1}{3}\begin{bmatrix} 1 & a & a^2 \\ 1 & a^2 & a \\ 1 & 1 & 1 \end{bmatrix}\begin{bmatrix} U'_{RS} \\ U'_{ST} \\ U'_{TR} \end{bmatrix}$$

- obtaining the system formed by the line-to-neutral voltages (U'$_R$, U'$_S$, U'$_T$) from the line-to-line voltage system (U'$_D$, U'$_I$, U'$_H$):

$$\begin{bmatrix} U'_R \\ U'_S \\ U'_T \end{bmatrix} = \begin{bmatrix} 1 & 1 & 1 \\ a^2 & a & 1 \\ a & a^2 & 1 \end{bmatrix}\begin{bmatrix} U'_D \\ U'_I \\ U'_H \end{bmatrix}$$

taking into account the properties:

$$U'_D = U'_{CD}\varepsilon^{-1}$$

$$U'_I = U'_{CI}\varepsilon^{*-1}$$

$$U'_H = U'^{*}_I$$

where:

$$\varepsilon = -\frac{1}{2}\left(3 + j\sqrt{3}\right); \varepsilon^* = -\frac{1}{2}\left(3 - j\sqrt{3}\right).$$

- rotating in a clockwise direction the system formed by the line-to-neutral voltages by the angle $\alpha$ calculated above:

○ $U_R = |U'_R|e^{j[angle(U'_R)-\alpha]}$

○ $U_S = |U'_S|e^{j[angle(U'_S)-\alpha]}$

○ $U_T = |U'_T|e^{j[angle(U'_T)-\alpha]}$

The method of balancing herein disclosed is dynamic, since it takes into account the true state of the three-phase system and balances it based on that true state and not on other types of considerations, such as the pre-defined tables of the prior art.

In a second aspect of the invention, a method for converting line-to-line voltages ($U_{RS}$, $U_{ST}$, $U_{TR}$) to line-to-neutral voltages ($U_R$, $U_S$, $U_T$) is disclosed, which comprises the following steps:

- calculating the line-to-line voltage system ($U_{CD}$, $U_{CI}$, $U_{CH}$) formed by the positive sequence line-to-line voltage ($U_{CD}$), the negative sequence line-to-line voltage ($U_{CI}$) and the zero sequence line-to-line voltage ($U_{CH}$), associated with the line-to-line voltages ($U_{RS}$, $U_{ST}$, $U_{TR}$):

$$\begin{bmatrix} U_{CD} \\ U_{CI} \\ U_{CH} \end{bmatrix} = \frac{1}{3} \begin{bmatrix} 1 & a & a^2 \\ 1 & a^2 & a \\ 1 & 1 & 1 \end{bmatrix} \begin{bmatrix} U_{RS} \\ U_{ST} \\ U_{TR} \end{bmatrix}$$

  ◦ where $a = e^{j\frac{2\pi}{3}}$

- calculating the angle "a" of the positive sequence and subtract $\pi/6$:

$$\alpha = angle(U_{CD}) - \frac{\pi}{6}$$

  ◦ where:
$$angle(U_{CD}) = atan2\left(\frac{imag(U_{CD})}{real(U_{CD})}\right)$$

- rotating in a counterclockwise direction the system formed by the line-to-line voltages by the angle $\alpha$ calculated above:

$$U'_{RS} = |U_{RS}|e^{j[angle(U_{RS})-\alpha]}$$

$$U'_{ST} = |U_{ST}|e^{j[angle(U_{ST})-\alpha]}$$

$$U'_{TR} = |U_{TR}|e^{j[angle(U_{TR})-\alpha]}$$

- calculating the positive sequence line-to-line voltage ($U'_{CD}$), the negative sequence line-to-line voltage ($U'_{CI}$) and the zero sequence line-to-line voltage ($U'_{CI}$) of the rotated line-to-line voltage system:

$$\begin{bmatrix} U'_{CD} \\ U'_{CI} \\ U'_{CH} \end{bmatrix} = \frac{1}{3} \begin{bmatrix} 1 & a & a^2 \\ 1 & a^2 & a \\ 1 & 1 & 1 \end{bmatrix} \begin{bmatrix} U'_{RS} \\ U'_{ST} \\ U'_{TR} \end{bmatrix}$$

- obtaining the system formed by the line-to-neutral voltages ($U'_R$, $U'_S$, $U'_T$) from the line-to-line voltage system ($U'_D$, $U'_I$, $U'_H$):

$$\begin{bmatrix} U'_R \\ U'_S \\ U'_T \end{bmatrix} = \begin{bmatrix} 1 & 1 & 1 \\ a^2 & a & 1 \\ a & a^2 & 1 \end{bmatrix} \begin{bmatrix} U'_D \\ U'_I \\ U'_H \end{bmatrix}$$ taking into account the properties:

$$U'_D = U'_{CD}\varepsilon^{-1}$$

$$U'_I = U'_{CI}\varepsilon^{*-1}$$

$$U'_H = U'^{*}_I$$

where:

$$\varepsilon = -\frac{1}{2}\left(3 + j\sqrt{3}\right); \varepsilon^* = -\frac{1}{2}\left(3 - j\sqrt{3}\right).$$

- rotating in a clockwise direction the system formed by the line-to-neutral voltages by the angle $\alpha$ calculated above:

$$\circ \ U_R = |U_R'|e^{j[angle(U_R')-\alpha]}$$

$$\circ \ U_S = |U_S'|e^{j[angle(U_S')-\alpha]}$$

$$\circ \ U_T = |U_T'|e^{j[angle(U_T')-\alpha]}$$

In general, the line-to-line voltages can be directly measured at the output of the three-phase systems. This second aspect of the invention is complementary to the first aspect of the invention, but it could also be used independently.

In a third aspect of the invention, a three-phase system is disclosed that comprises the method of electrical balancing defined in the first aspect of the invention.

In a fourth aspect of the invention, a three-phase system is disclosed that comprises the method of electrical balancing defined in the second aspect of the invention.

In one embodiment of the third aspect of the invention, the three-phase system comprises:

- a three-phase power outlet (R,S,T);
- power cells connected in cascade by each power line;
- a control card for each power cell, the control card is configured to measure the voltage supplied by the cell with which the control card is associated and to modify the voltage of the power cell;
- control equipment connected to each control card and to the three-phase power outlet (R,S,T) to obtain the magnitude and phase of each line-to-neutral voltage ($U_R$, $U_S$, $U_T$);

such that the control equipment modifies the magnitude and phase of the voltage of each cell by means of each control card until the three-phase system output reaches the new line-to-neutral voltages ($U_R$", $U_S$", $U_T$").

In another embodiment of the third aspect of the invention, the power cell further comprises a bypass circuit, where the bypass circuit is closed when it receives a closing command from the control card.

## BRIEF DESCRIPTION OF THE FIGURES

Figure 1 shows a medium-voltage drive that comprises control equipment where the method of balancing voltages of the present invention is implemented.

Figure 2 shows a power cell comprised in the medium-voltage drive.

Figure 3 shows a drive with five cells in phase and with failure in three cells (cells C4, C5 and B5 which are not shown in the figure because they have failed).

Figure 4 shows a medium-voltage drive with imbalances caused by the inequality of the power cells in the manufacture thereof.

Figure 5 shows a breakdown of an unbalanced system in positive, negative and zero sequences thereof.

Figure 6 shows a vector breakdown of the Positive Sequence "SD".

Figure 7 shows a vector breakdown of the Negative Sequence "SI".

Figure 8 shows a vector breakdown of the Negative Sequence "SI" transformed in a counterclockwise direction.

Figure 9 shows a vector breakdown of the Negative Sequence "SI" in a vector system equivalent to that of Figure 8.

Figure 10 shows a vector breakdown of the Zero Sequence "SH".

Figure 11 shows a flow chart of the method of electrical balancing in three-phase systems.

Figure 12 shows a vector representation of the line-to-neutral output voltages of an unbalanced power drive with alignment of an output voltage on the real axis.

Figure 13 shows a vector representation of the output voltages where each one is the complex conjugate of the other.

Figure 14 shows a vector representation of the balanced line-to-line output voltages where the canceled negative sequence condition is fulfilled.

Figure 15 shows a vector representation of the balanced line-to-line output voltages where the shutdown condition of the method is fulfilled.

## PREFERRED EMBODIMENT OF THE INVENTION

An exemplary embodiment of the invention is described below by way of illustration and not limitation.

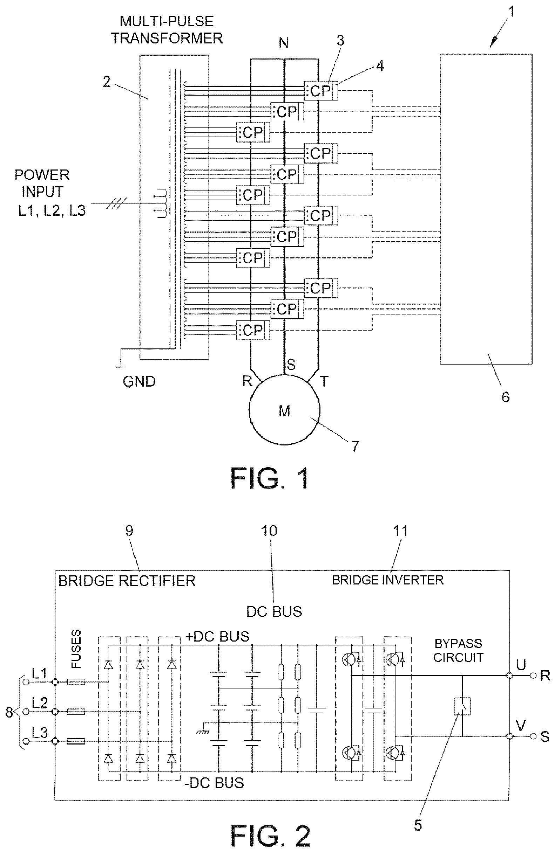

For the exemplary embodiment, Figure 1 shows the topology of a medium-voltage drive **1** whose three-phase output (R,S,T) is connected to a motor **7.** The medium-voltage drive **1** comprises a phase-changing rectifier transformer **2,** power cells **3** connected in cascade, a control card **4,** control equipment **6** and a bypass circuit **5.** The control card **4** is responsible for measuring the voltage supplied by the cell with which it is associated and detecting, if any, a failure in the cell. The control card **4** communicates with the control equipment **6.** The control equipment **6** can give commands to the control card **4** to close the bypass circuit **5** in the case of failure of the power cell. Alternatively, the control card **4** can close the bypass circuit **5** automatically when the card **4** detects a failure in the power cell **3.** The control equipment **6** implements the method of balancing voltages (or currents) in a way that by acting on each of the power cells, the power output of the drive **1** is balanced. The actuation of the control equipment **6** on each power cell **3** is carried out by independently modifying the magnitude and phase of the voltage or current of each power cell according to the method of the present invention. As described below, the method of the present invention makes it possible to obtain a completely balanced power outlet in line-to-line voltages or currents, both if there is a failure in one of the power cells or if there are power fluctuations in some of the power cells due to structural differences in the manufacture thereof and/or in the voltage/current supply that the power cells receive.

The power cell **3** is shown in Figure **2.** The power cell **3** consists of a basic single-pole inverter circuit AC-DC-AC. The cell has three inputs **8** of alternating current **L1, L2, L3,** which are connected to a bridge rectifier **9,** which is a diode bridge. The bridge rectifier **9** is connected to a DC bus **10,** which is connected to a bridge inverter **11.** The bypass circuit **5** is placed at the output of the bridge inverter. The bridge inverter is made up of IGBTs that generate single-phase voltage waves PWM.

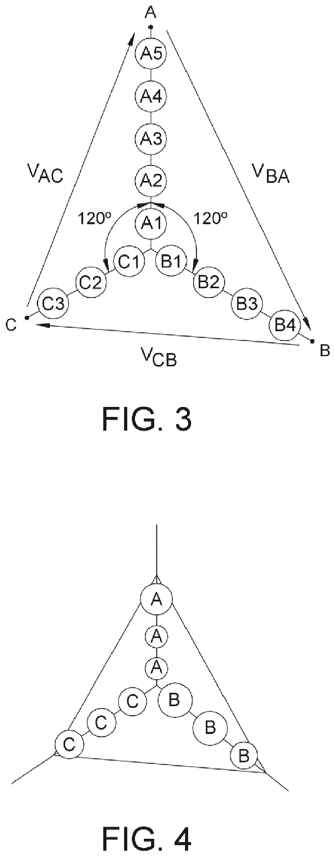

In the case of failure of one or more cells, the bypass circuit **5** is closed, creating an alternating current path that allows the drive **1** to continue to operate. The output will be an unbalanced system, as shown in Figure 3. In this case, Figure 3 shows the output of a drive with five cells in phase and with failure in three cells (cells C4, C5 and B5 which are not shown in the figure because they have failed).

Furthermore, circumstances may exist where the cells do not provide the same voltage (or current), which generates imbalances at the output of the medium-voltage drive **1.** These types of imbalances may lead to situations such as those shown in Figure 4. Like in the case of failure of a power cell, the control card **4** detects the power fluctuations of the cell with which it is associated, since it constantly measures the power of the power cell.

It is important to remember that the line-to-neutral voltages ($U_R$, $U_S$, $U_T$) of the drive **1** are the result of the sum of each of the cells of the corresponding phase (R, S, T; they can also be found in the state of the art as U, V, W). To obtain the line-to-line voltages ($U_{RS}$, $U_{ST}$, $U_{TR}$), in a three-phase electrical system, it is only necessary to subtract the two line-to-neutral voltages ($U_{RS} = U_S - U_R$; $U_{ST} = U_T - U_S$; $U_{TR} = U_R - U_T$). Measuring the line-to-line voltages at the output of a transformer is easy and known in the state of the art. However, obtaining the line-to-neutral voltages from the line-to-line voltages is not known in the state of the art. In the present disclosure, line-to-line voltages or a line-to-line voltage system are mentioned indistinctly as the set of the line-to-line voltages, the latter being preferred for the graphic representation thereof as vectors (phasors) of the line-to-line voltages.

Once the above is remembered, it must be considered that any system (drive, converter, etc.) that has a failed power cell will have unbalanced line-to-neutral voltages as well as unbalanced line-to-line voltages.

Before going into detail about the method of the present invention, it is important to remember certain concepts. Fortescue's Theorem or the method of symmetrical components makes it possible to express in a general way an unbalanced polyphase system in a steady state (with n phases) as the sum of "n" balanced systems by applying the principle of superposition.

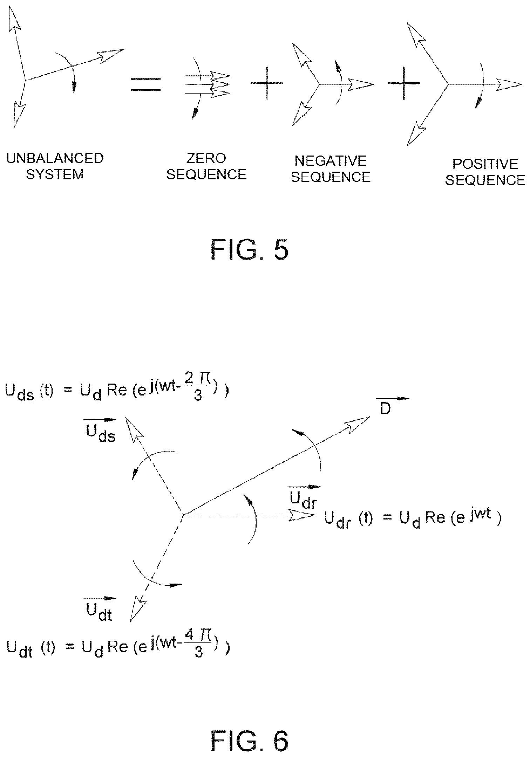

In particular, an unbalanced three-phase electrical system in a steady state may be broken down into a balanced positive sequence three-phase system plus a balanced negative sequence three-phase system plus a zero sequence system, see Figure 5.

The Positive Sequence ($\vec{D}$), or "SD" (Direct Sequence), is a balanced three-phase sinusoidal system of voltages (or currents) of the same amplitude but separated over time and in space by 120 electrical degrees in the counterclockwise direction, see Figure 6.

The temporal electrical system can be expressed as a vector of three components:

$$\overrightarrow{U_D}(t) = [U_{DR}(t), U_{DS}(t), U_{DT}(t)]$$

Each component of the system can, in turn, be expressed as a temporal phasor that rotates in the space in a counterclockwise direction.

$$\overrightarrow{U_{DR}} = U_D e^{j\omega t} \qquad \rightarrow U_{DR}(t) = Re\left(\overrightarrow{U_{DR}}\right)$$

$$\overrightarrow{U_{DS}} = U_D e^{j\left(\omega t - \frac{2\pi}{3}\right)} \qquad \rightarrow U_{DS}(t) = Re\left(\overrightarrow{U_{DS}}\right)$$

$$\overrightarrow{U_{DT}} = U_D e^{j\left(\omega t - \frac{4\pi}{3}\right)} \qquad \rightarrow U_{DT}(t) = Re\left(\overrightarrow{U_{DT}}\right)$$

Another more compact way of representing the three-phase electrical system is via the spatial vector thereof. To obtain it, it is enough to place the temporal magnitudes (not the phasors thereof) on each spatial axis and add them up:

$$\overrightarrow{U_{DR}} = U_{DR} e^{j0} = U_D Re\left(e^{j\omega t}\right) e^{j0}$$

$$\overrightarrow{U_{DS}} = U_{DS} e^{j\frac{2\pi}{3}} = U_D Re\left(e^{j\left(\omega t - \frac{2\pi}{3}\right)}\right) e^{j\frac{2\pi}{3}}$$

$$\overrightarrow{U_{DT}} = U_{DT} e^{j\frac{2\pi}{3}} = U_D Re\left(e^{j\left(\omega t - \frac{4\pi}{3}\right)}\right) e^{j\frac{4\pi}{3}}.$$

$$\vec{D} = U_D \sum_{k=0}^{2} Re\left[e^{j\left(\omega t + k\frac{2\pi}{n}\right)}\right] e^{jk\frac{2\pi}{n}} = \frac{3}{2} U_D e^{j\omega t}$$

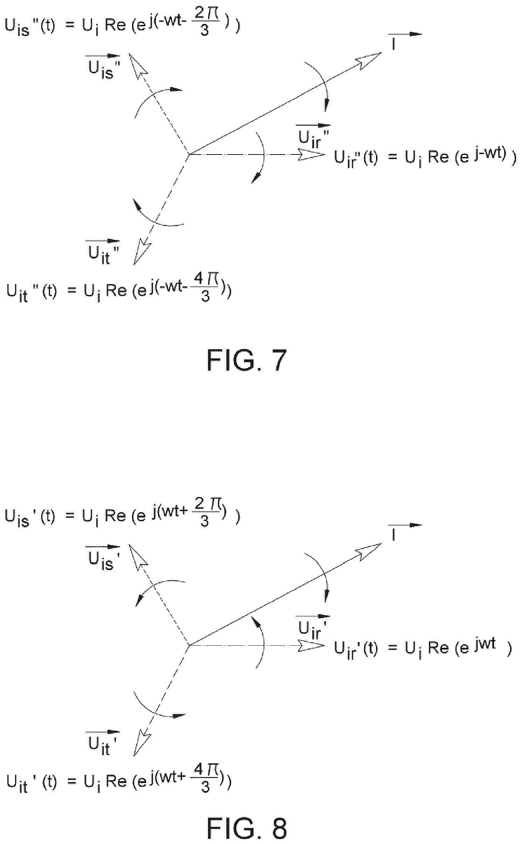

The Negative Sequence ($\vec{I}$), or "SI" (Inverse Sequence) is a balanced three-phase sinusoidal system of voltages (or currents) of the same amplitude but separated over time and space by 120 electrical degrees in the clockwise direction, see Figure 7. Since the cosine function is even, the voltage system shown in Figure 7 is equivalent to a system with temporal phasors that rotate in a counterclockwise direction (in positive sequence) in the following way (see Figure 8):

$$\left.\begin{array}{l} \overrightarrow{U_{ir}}'' = U_i e^{-j\omega t} \\ \overrightarrow{U_{is}}'' = U_i e^{-j\left(\omega t + \frac{2\pi}{3}\right)} \\ \overrightarrow{U_{it}}'' = U_i e^{-j\left(\omega t + \frac{4\pi}{3}\right)} \end{array}\right\} \Longleftrightarrow \left\{\begin{array}{l} \overrightarrow{U_{ir}}' = U_i e^{j\omega t} \\ \overrightarrow{U_{is}}' = U_i e^{j\left(\omega t + \frac{2\pi}{3}\right)} \\ \overrightarrow{U_{it}}' = U_i e^{j\left(\omega t + \frac{4\pi}{3}\right)} \end{array}\right.$$

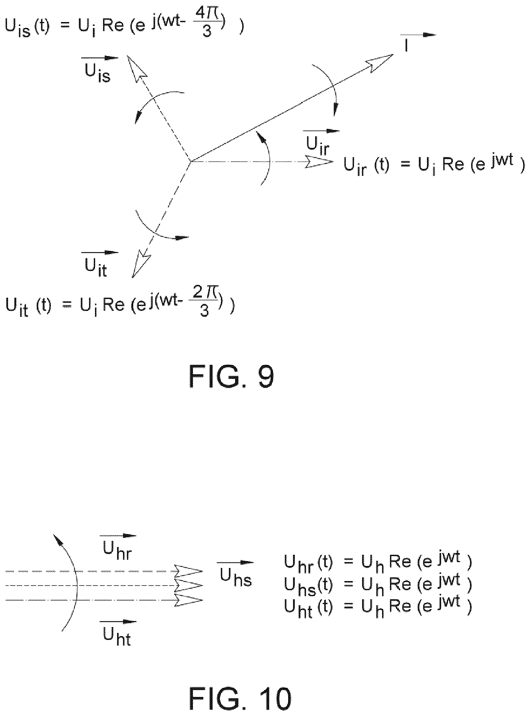

The latter system that is equivalent to the previous system also has another equivalent (Figure 9):

$$\left.\begin{array}{l} \overrightarrow{U_{ir}}'' = U_i e^{-j\omega t} \\ \overrightarrow{U_{is}}'' = U_i e^{-j\left(\omega t + \frac{2\pi}{3}\right)} \\ \overrightarrow{U_{it}}'' = U_i e^{-j\left(\omega t + \frac{4\pi}{3}\right)} \end{array}\right\} \Longleftrightarrow \left\{\begin{array}{l} \overrightarrow{U_{ir}}' = U_i e^{j\omega t} \\ \overrightarrow{U_{is}}' = U_i e^{j\left(\omega t + \frac{2\pi}{3}\right)} \\ \overrightarrow{U_{it}}' = U_i e^{j\left(\omega t + \frac{4\pi}{3}\right)} \end{array}\right\} \Longleftrightarrow \left\{\begin{array}{l} \overrightarrow{U_{ir}} = U_i e^{j\omega t} \\ \overrightarrow{U_{is}} = U_i e^{j\left(\omega t - \frac{4\pi}{3}\right)} \\ \overrightarrow{U_{it}} = U_i e^{j\left(\omega t - \frac{2\pi}{3}\right)} \end{array}\right.$$

Although the rotation direction of the temporal phasors changes, the direction of the associated spatial phasor does not:

$$\overrightarrow{U_{IR}} = U_{ir} e^{j0} = U_i Re\left(e^{j\omega t}\right) e^{j0}$$

$$\overrightarrow{U_{IS}} = U_{is} e^{j\frac{2\pi}{3}} = U_i Re\left(e^{j\left(\omega t - \frac{4\pi}{3}\right)}\right) e^{j\frac{2\pi}{3}}$$

$$\overrightarrow{U_{IT}} = U_{it}e^{j\frac{2\pi}{3}} = U_i Re\left(e^{j\left(\omega t - \frac{2\pi}{3}\right)}\right)e^{j\frac{4\pi}{3}}.$$

$$\vec{I} = U_i \sum_{k=0}^{2} Re\left[e^{j\left(\omega t - k\frac{4\pi}{n}\right)}\right]e^{jk\frac{2\pi}{n}} = U_i \sum_{k=0}^{2} Re\left[e^{j\left(\omega t + k\frac{2\pi}{n}\right)}\right]e^{jk\frac{2\pi}{n}} = \frac{3}{2}U_i e^{-j\omega t}$$

The Zero Sequence ($\vec{H}$), or "SH" (Sequence Homopolar), is a balanced system of three sinusoidal voltages (or currents) of the same amplitude and phase and located in the same place in space, see Figure 10.

The temporary electrical system can be expressed as a vector of three components:

$$\overrightarrow{U_H}(t) = [U_{hr}(t), U_{hs}(t), U_{ht}(t)]$$

Each component of the system can in turn be expressed as a temporary phasor that rotates in the space in a counterclockwise direction:

$$\overrightarrow{U_{hr}} = U_h e^{j\omega t} \qquad\qquad \blacktriangleright U_{hr}(t) = Re\left(\overrightarrow{U_{hr}}\right)$$

$$\overrightarrow{U_{hs}} = U_h e^{j\omega t} \qquad\qquad \blacktriangleright U_{hs}(t) = Re\left(\overrightarrow{U_{hs}}\right)$$

$$\overrightarrow{U_{ht}} = U_h e^{j\omega t} \qquad\qquad \blacktriangleright U_{ht}(t) = Re\left(\overrightarrow{U_{ht}}\right)$$

In the case of zero sequence, it is not possible to obtain an associated spatial vector, since the spatial vectors exclusively represent complex polyphase systems.

Therefore, an unbalanced electrical voltage system may be broken down into the following sequences: positive, negative and zero.

$$\begin{bmatrix} U_d \\ U_i \\ U_h \end{bmatrix} = \frac{1}{3}\begin{bmatrix} 1 & a & a^2 \\ 1 & a^2 & a \\ 1 & 1 & 1 \end{bmatrix}\begin{bmatrix} U_r \\ U_s \\ U_t \end{bmatrix}$$

$$U_d = \frac{1}{3}(U_r + U_s a + U_t a^2)$$

$$U_i = \frac{1}{3}(U_r + U_s a^2 + U_t a)$$

$$U_h = \frac{1}{3}(U_r + U_s + U_t)$$

$$a = e^{j\frac{2\pi}{3}}$$

If the negative sequence voltage $U_i$ obtained from the previous expression is subtracted from the original voltage system, the new voltage system will not have negative sequence, and therefore, it could be written as follows:

$$\begin{bmatrix} U_r \\ U_s \\ U_t \end{bmatrix} = \begin{bmatrix} 1 & 1 & 1 \\ a^2 & a & 1 \\ a & a^2 & 1 \end{bmatrix} \begin{bmatrix} U_d \\ 0 \\ U_h \end{bmatrix}$$

$$\begin{bmatrix} U_r' \\ U_s' \\ U_t' \end{bmatrix} = \begin{bmatrix} 1 & 1 & 1 \\ a^2 & a & 1 \\ a & a^2 & 1 \end{bmatrix} \begin{bmatrix} U_d \\ 0 \\ U_h \end{bmatrix} = \frac{1}{3} \begin{bmatrix} 1 & 1 & 1 \\ a^2 & a & 1 \\ a & a^2 & 1 \end{bmatrix} \begin{bmatrix} U_r + U_s a + U_t a^2 \\ 0 \\ U_r + U_s + U_t \end{bmatrix}$$

$$U_r' = \frac{1}{3} [(U_r + U_s a + U_t a^2) + (U_r + U_s + U_t)]$$

$$U_s' = \frac{1}{3} [a^2(U_r + U_s a + U_t a^2) + (U_r + U_s + U_t)]$$

$$U_t' = \frac{1}{3} [a(U_r + U_s a + U_t a^2) + (U_r + U_s + U_t)]$$

Carrying out:

$$U_r' = \frac{1}{3} [2U_r + U_s(1 + a) + U_t(1 + a^2)]$$

$$U_s' = \frac{1}{3} [U_r(1 + a^2) + U_s(1 + a^3) + U_t(1 + a^4)]$$

$$U_t' = \frac{1}{3} [U_r(1 + a) + U_s(1 + a^2) + U_t(1 + a^3)]$$

Remembering that:

$$1 + a + a^2 = 0$$

$$1 + a^3 + a^3 = 3$$

$$U_r' = \frac{1}{3} [2U_r - U_s a^2 - U_t a]$$

$$U_s' = \frac{1}{3} [-U_r a + 2U_s - U_t a^2]$$

$$U_t' = \frac{1}{3} [-U_r a^2 - U_s a + 2U_t]$$

$$\left\{ \begin{array}{l} U_r{}' = \frac{1}{3}\left[2U_r - U_t a - U_s a^2\right] \\[2em] U_s{}' = \frac{1}{3}\left[2U_s - U_r a - U_t a^2\right] \\[2em] U_t{}' = \frac{1}{3}\left[2U_t - U_s a - U_r a^2\right] \end{array} \right\}$$

This system formed by the voltages ($U_R$', $U_S$', $U_T$') is also unbalanced in line-to-neutral voltages, but not in line-to-line voltages. Furthermore, it does not have negative sequence, as it has been forced.

The method herein described based on the cancelation of the negative sequence has drawbacks such as the new line-to-neutral voltages ($U_R$', $U_S$', $U_T$') that are greater than the available line-to-neutral voltages ($U_R$, $U_S$, $U_T$), which would not be possible to carry out or which are lesser than those voltages, which would decrease the performance of the three-phase system.

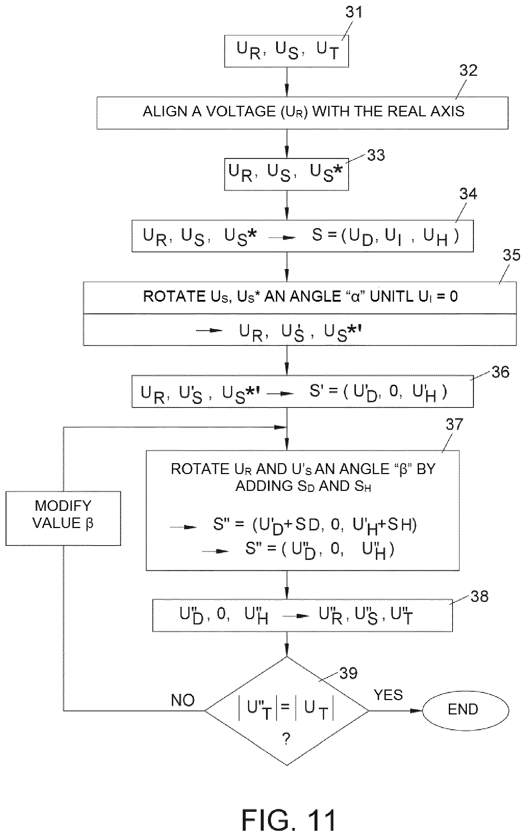

Figure 11 shows a flow chart of the method of electrical balancing for a three-phase system that, for the present exemplary embodiment, is the medium-voltage drive **1** shown in Figure 1. This method makes it possible to balance the three-phase system in line-to-line voltages (or currents), using 100% of the line-to-neutral voltages available.

Step 1 (Figure 11; **31**) - Knowledge of the amplitude and phase of the three line-to-neutral output voltages ($U_R$, $U_S$, $U_T$) of the drive is used. If it is not possible to obtain the line-to-neutral voltages ($U_R$, $U_S$, $U_T$), but rather the line-to-line voltages ($U_{RS}$, $U_{ST}$, $U_{TR}$), the conversion of line-to-line voltages to line-to-neutral voltages is applied as detailed below.

The method of the present invention is based on the construction of any balanced line-to-line voltage system from the existing line-to-neutral voltages and it progressively adds (adding or subtracting) positive sequence voltage and zero sequence voltage until the maximum voltage possible is obtained. The method ensures the balancing of the line-to-line voltages which is what the load (motor 7) connected to the drive 1 "sees". The following steps of the method are as described below.

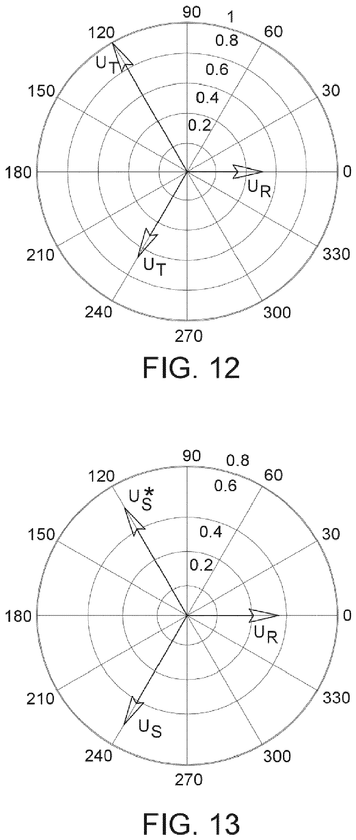

Step 2 (Figure 11; **32**) - Given an unbalanced electrical voltage (or current) system, one of the voltages ($U_R$) thereof is aligned with the real axis (see Figure 12).

Step 3 (Figure 11; **33**) - Two of the (any) available line-to-neutral voltages $U_R$, Us are chosen, including the line-to-neutral voltage of step 2 ($U_R$): $U_R$, $U_S$ and a third voltage $U^*_S$ is added, which is the complex conjugate of the greater of the two previous voltages (see Figure 13).

Step 4 (Figure 11; **34**) - The system formed by the symmetrical components -S- (positive sequence voltage $U_D$, negative sequence voltage $U_I$ and zero sequence voltage $U_H$) is calculated: S = ($U_D$, $U_I$, $U_H$) of the line-to-neutral voltages ($U_R$, $U_S$, $U^*_S$) of step 3:

- $U_D = \frac{1}{3}(U_R + U_S a + U_S^* a^2)$
- $U_I = \frac{1}{3}(U_R + U_S a^2 + U_S^* a)$
- $U_H = \frac{1}{3}(U_R + U_S + U_S^*)$

where $a = e^{j\frac{2\pi}{3}}$.

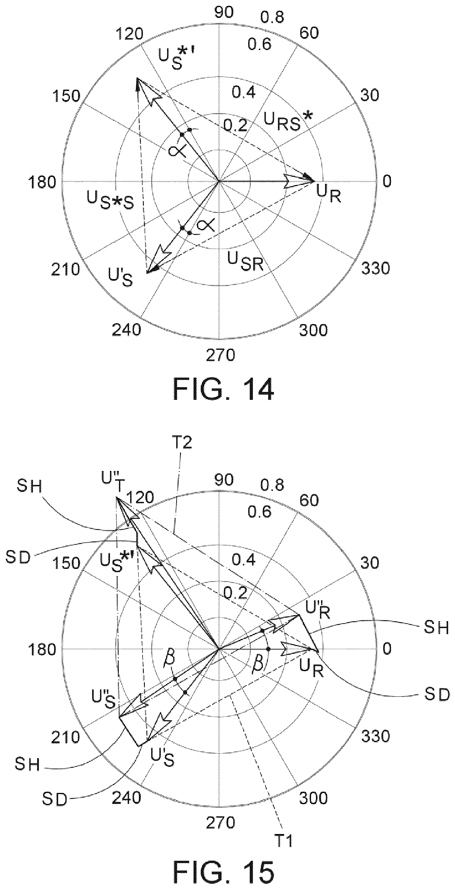

Step 5 (Figure 11; **35**) - The negative sequence "SI" (negative sequence voltage $U_I$) is subtracted from this system -S- until a three-phase system -S'-without negative sequence ($U_I$ =0), but maintaining the module of the original vectors is built, (see Figure 14):

$$|U_s| = |U_s'|$$

$$|U_s^{*'}| = |U_s^*|$$

$$S' = (U_D', 0, U_H')$$

To immediately obtain the vectors $U_S'$, $U^*_S'$, both vectors are rotated by an angle $\alpha$ with the aim of maintaining the module until the ends of the three vectors form an equilateral triangle:

$$(U_S' \cos(\alpha) + U_R) \tan\left(\frac{\pi}{6}\right) = U_S' \sin(\alpha)$$

$$U_S^{*\prime} = conj(U_S')$$

The equilateral triangle, shown in Figure 14, is formed by the line-to-line voltages ($U_{RS*}$, $U_{SR}$, $U_{S*S}$) of the three-phase system -S'-. Therefore, Figure 14 already shows a balanced line-to-line voltage system, although it is unbalanced in line-to-neutral voltages ($U_R$, $U_S'$, $U^*_S'$). But this system -S'- is not maximized since the voltage $U^*_S'$ is less than the original voltage ($U_T$) available, $U_R$ continues to be the original voltage in magnitude and phase, and $U_S'$ is equal in magnitude to the original voltage $U_S$, but different in phase.

Step 6 (Figure 11; **36**) - the new positive sequence voltage ($U_D'$) and the new zero sequence voltage ($U_H'$) of the new line-to-neutral voltage system ($U_R$, $U_S'$, $U^*_S'$) are calculated;

The system thus formed does not have negative sequence and the positive sequence voltage and zero sequence voltage thereof are obtained from:

$$\begin{bmatrix} U_D' \\ 0 \\ U_H' \end{bmatrix} = \frac{1}{3} \begin{bmatrix} 1 & a & a^2 \\ 1 & a^2 & a \\ 1 & 1 & 1 \end{bmatrix} \begin{bmatrix} U_R \\ U_S' \\ U_S^{*\prime} \end{bmatrix}$$

The following step achieves optimization of the three-phase system since all phases of the three voltages ($U_R$, $U_S'$, $U^*_S'$) are modified, increasing the magnitude of $U^*_S'$ until reaching $U_T$ and maintaining the magnitudes of the voltages $U_R$, $U_S'$.

Step 7 (Figure 11; **37**) - A pair of positive sequence SD (positive sequence voltage) and zero sequence SH (zero sequence voltage) systems are added progressively to the system -S'-, thus obtaining the system S":

$$S'' = (U_D' + SD, 0, U_H' + SH)$$

such that the module of the voltages $U_R$, $U_S'$ remains constant. By doing this, the resulting line-to-line voltage system will continue to increase the size thereof without become unbalanced.

Step 8 (Figure 11; **38**) - The line-to-neutral voltages ($U_R''$, $U_S''$, $U_T''$) associated with the system S" are calculated. Therefore, $U_R''$, $U_S''$ are equal in magnitude to $U_R''$, $U_S'$, respectively, but different in phase.

Step 9 (Figure 11; **39**) - The module of the third line-to-neutral voltage ($U_T''$) calculated in step 8 is compared to the module of the line-to-neutral voltage discarded in step 3 (see Figure 15):

$$|U_T''| = |U_t|.$$

If both modules are equal, the method ends and the balanced line-to-line voltages are $U_R''$, $U_S''$, $U_T''$.

If both modules are different, steps 7 and 8 are repeated, modifying the positive sequence (SD) and zero sequence (SH) voltages. This is equivalent to modifying "$\beta$".

Figure 15 shows two equilateral triangles. One of them T1 coincides with that shown in Figure 14 which would be formed by the line-to-neutral voltages ($U_R$, $U_S'$, $U^*_S'$). The second T2 is formed by rotation of an angle $\beta$ in a counterclockwise direction of $U_R$ ($\to U_R''$), and by rotation of that same angle $\beta$ in a clockwise direction of $U_S'$ ($\to U_S''$). The modification of the phase of the potentials $U_R$ y $U_S'$ by an angle $\beta$ is equivalent to adding a positive sequence potential and a zero sequence potential, which added to $U^*_S'$ results in $U_T''$.

Similar to that carried out in step 5, in step 6 the vector $U_R$ is rotated by an angle $\beta$ in a counterclockwise (or clockwise) direction and $U_S'$ is rotated by the same angle, but in the direction opposite to the previous direction, with the intention of maintaining the modules of these 2 vectors:

$$U_R'' = U_R e^{j\beta}$$

$$U_S'' = U_S' e^{-j\beta}$$

This movement must correspond to the addition of a specific positive sequence "SD" ($U_D$) and zero sequence "SH" ($U_H$) quantity. To calculate these quantities, it must be remembered that the positive sequence is a set of three vectors with the same amplitude and separated $\dfrac{2\pi}{3}$ from each other [$SD_r$,$SD_s$,$SD_t$]:

$$|SD_r| = |SD_s| = |SD_t| = SD$$

$$SD_r = SD e^{j0}$$

$$SD_s = SD e^{j\frac{4\pi}{3}}$$

$$SD_t = SD e^{j\frac{2\pi}{3}}$$

If they are rotated by a specific angle:

$$SD_r = SD e^{j\gamma}$$

$$SD_s = SD e^{j\left(\frac{4\pi}{3}+\gamma\right)}$$

$$SD_t = SD e^{j\left(\frac{2\pi}{3}+\gamma\right)}$$

The same occurs with the zero sequence:

$$SH_r = SH e^{j\delta}$$

$$SD_s = SH e^{j\delta}$$

$$SD_t = SH e^{j\delta}$$

Therefore, the following system of equations is obtained:

$$\left.\begin{aligned} U_R + SD_r + SH_r = U_R'' \\ U_S' + SD_s + SH_s = U_S'' \end{aligned}\right\}$$

$$\left.\begin{aligned} U_r + SD e^{j0} + SH e^{j\delta} = U_r e^{j\beta} \\ U_s' + SD e^{j\frac{4\pi}{3}} + SH e^{j\delta} = U_s' e^{-j\beta} \end{aligned}\right\}$$

Developing:

$$\begin{cases} U_R = real(U_R) + jimag(U_R) \\ U_R'' = real(U_R'') + jimag(U_R'') \\ U_s' = real(U_s') + jimag(U_s') \\ U_s'' = real(U_s'') + jimag(U_s'') \\ SD_r = SD_{rx} + jSD_{ry} \\ SD_s = (SD_{rx} + jSD_{ry})\left(cos\left(\frac{4\pi}{3}\right) + jsin\left(\frac{4\pi}{3}\right)\right) \\ SH = SH_x + jSH_y \end{cases}$$

$$\begin{cases} real(U_R) + jimag(U_R) + SD_{rx} + jSD_{ry} + SH_x + jSH_y = real(U_R'') + \\ jimag(U_R'') \\ real(U_s') + jimag(U_s') + SD_{rx}cos\left(\frac{4\pi}{3}\right) + jSD_{rx}sin\left(\frac{4\pi}{3}\right) - SD_{ry}sin\left(\frac{4\pi}{3}\right) \\ \qquad + jSD_{ry}cos\left(\frac{4\pi}{3}\right) + SH_x + jSH_y = real(U_s'') + jimag(U_s'') \end{cases}$$

These two equations are divided into a linear system of four equations:

$$\begin{cases} real(U_R) + SD_{rx} + SH_x = real(U_R'') \\ imag(U_R) + SD_{ry} + SH_y = imag(U_R'') \\ real(U_s') + SD_{rx}cos\left(\frac{4\pi}{3}\right) - SD_{ry}sin\left(\frac{4\pi}{3}\right) + SH_x = real(U_s'') \\ imag(U_s') + SD_{rx}sin\left(\frac{4\pi}{3}\right) + SD_{ry}cos\left(\frac{4\pi}{3}\right) + SH_y = imag(U_s'') \end{cases}$$

Separating terms:

$$SD_{rx} + SH_x = real(U_R'') - real(U_R)$$

$$SD_{ry} + SH_y = imag(U_R'') - imag(U_R)$$

$$SD_{rx}cos\left(\frac{4\pi}{3}\right) - SD_{ry}sin\left(\frac{4\pi}{3}\right) + SH_x = real(U_s'') - real(U_s')$$

$$SD_{rx}sin\left(\frac{4\pi}{3}\right) + SD_{ry}cos\left(\frac{4\pi}{3}\right) + SH_y = imag(U_s'') - imag(U_s')$$

Writing this system in matrix form:

$$
\begin{pmatrix}
1 & 0 & 1 & 0 \\
0 & 1 & 0 & 1 \\
\cos\left(\frac{4\pi}{3}\right) & \sin\left(\frac{4\pi}{3}\right) & 1 & 0 \\
-\sin\left(\frac{4\pi}{3}\right) & \cos\left(\frac{4\pi}{3}\right) & 0 & 1
\end{pmatrix}
\begin{pmatrix} SD_{rx} \\ SD_{ry} \\ SH_x \\ SH_y \end{pmatrix}
=
\begin{pmatrix}
-1 & 0 & 0 & 0 & 1 & 0 & 0 & 0 \\
0 & -1 & 0 & 0 & 0 & 1 & 0 & 0 \\
0 & 0 & -1 & 0 & 0 & 0 & 1 & 0 \\
0 & 0 & 0 & -1 & 0 & 0 & 0 & 1
\end{pmatrix}
\begin{pmatrix}
real(U_R) \\ imag(U_R) \\ real(U_s') \\ imag(U_s') \\ real(U_R') \\ imag(U_R') \\ real(U_s'') \\ imag(U_s'')
\end{pmatrix}
$$

Resulting in:

$$
\begin{pmatrix} SD_{rx} \\ SD_{ry} \\ SH_x \\ SH_y \end{pmatrix}
=
\begin{pmatrix}
1 & 0 & 1 & 0 \\
0 & 1 & 0 & 1 \\
\cos\left(\frac{4\pi}{3}\right) & \sin\left(\frac{4\pi}{3}\right) & 1 & 0 \\
-\sin\left(\frac{4\pi}{3}\right) & \cos\left(\frac{4\pi}{3}\right) & 0 & 1
\end{pmatrix}^{-1}
\begin{pmatrix}
-1 & 0 & 0 & 0 & 1 & 0 & 0 & 0 \\
0 & -1 & 0 & 0 & 0 & 1 & 0 & 0 \\
0 & 0 & -1 & 0 & 0 & 0 & 1 & 0 \\
0 & 0 & 0 & -1 & 0 & 0 & 0 & 1
\end{pmatrix}
\begin{pmatrix}
real(U_R) \\ imag(U_R) \\ real(U_s') \\ imag(U_s') \\ real(U_R') \\ imag(U_R') \\ real(U_s'') \\ imag(U_s'')
\end{pmatrix}
$$

Where:

$$
\begin{pmatrix}
1 & 0 & 1 & 0 \\
0 & 1 & 0 & 1 \\
\cos\left(\frac{4\pi}{3}\right) & \sin\left(\frac{4\pi}{3}\right) & 1 & 0 \\
-\sin\left(\frac{4\pi}{3}\right) & \cos\left(\frac{4\pi}{3}\right) & 0 & 1
\end{pmatrix}^{-1}
=
\begin{pmatrix}
-\cos\left(\frac{4\pi}{3}\right) & -\frac{1}{3}\sin\left(\frac{4\pi}{3}\right) & \cos\left(\frac{4\pi}{3}\right) & \frac{1}{3}\sin\left(\frac{4\pi}{3}\right) \\
\frac{1}{3}\sin\left(\frac{4\pi}{3}\right) & -\cos\left(\frac{4\pi}{3}\right) & -\frac{1}{3}\sin\left(\frac{4\pi}{3}\right) & \cos\left(\frac{4\pi}{3}\right) \\
-\cos\left(\frac{4\pi}{3}\right) & \frac{1}{3}\sin\left(\frac{4\pi}{3}\right) & -\cos\left(\frac{4\pi}{3}\right) & -\frac{1}{3}\sin\left(\frac{4\pi}{3}\right) \\
-\frac{1}{3}\sin\left(\frac{4\pi}{3}\right) & -\cos\left(\frac{4\pi}{3}\right) & \frac{1}{3}\sin\left(\frac{4\pi}{3}\right) & -\cos\left(\frac{4\pi}{3}\right)
\end{pmatrix}
$$

Once $SD_r = SD_{rx} + jSD_{ry}$ and $SH = SH_x + jSH_y$ are obtained, $SD_s$ and $SD_t$ can be obtained directly, and therefore, SD and SH.

Thus, the positive sequence and zero sequence system necessary for rotating the vector $U_R$ at an angle $\beta$ in a counterclockwise (or clockwise) direction and $U_S'$ at the same angle, but in the opposite direction to the previous direction, is perfectly determined.

If this positive sequence and zero sequence obtained is added to the starting system, we will obtain a voltage system without negative sequence:

$$(U_D' + SD, 0, U_H' + SH)$$

We previously called this new system $S'' = [U_D'', 0, U_H'']$.

From this positive sequence and zero sequence system, the line-to-neutral voltages thereof are obtained:

$$
\begin{bmatrix} U_R'' \\ U_S'' \\ U_T'' \end{bmatrix}
=
\begin{bmatrix}
1 & 1 & 1 \\
a^2 & a & 1 \\
a & a^2 & 1
\end{bmatrix}
\begin{bmatrix} U_D'' \\ 0 \\ U_H'' \end{bmatrix}
$$

Thus, $U_T''$ and the module thereof are determined; by comparing $|U_T''|$ to $|U_T|$, we will be able to calculate

the error:

$$Error = |U_T''| - |U_T|$$

And given this error, we will increase or reduce the angle β and we will carry out the calculations again until said error is less than a pre-established value ε.

In the previous cases, it is possible that the line-to-line voltages, and not the line-to-neutral voltages, are known. To be able to calculate the line-to-neutral voltages ($U_R$, $U_S$, $U_T$) from the line-to-line voltages ($U_{RS}$, $U_{ST}$, $U_{TR}$), the method further comprises the following sub-steps, which can be carried out within any main step of the method (or even in a different way), namely:

- calculating the symmetrical components, positive, negative and zero sequences, associated with the line-to-line voltages:

$$\begin{bmatrix} U_{CD} \\ U_{CI} \\ U_{CH} \end{bmatrix} = \frac{1}{3}\begin{bmatrix} 1 & a & a^2 \\ 1 & a^2 & a \\ 1 & 1 & 1 \end{bmatrix}\begin{bmatrix} U_{RS} \\ U_{ST} \\ U_{TR} \end{bmatrix}$$

  ○ being $a = e^{j\frac{2\pi}{3}}$ and
  ○ $U_{CD}$: positive sequence line-to-line voltage;
  ○ $U_{CI}$: negative sequence line-to-line voltage;
  ○ $U_{CH}$: zero sequence line-to-line voltage;

- calculating the angle "a" of the positive sequence and subtract $\pi/6$:

$$\alpha = angle(U_{CD}) - \frac{\pi}{6}$$

  ○ where:
$$angle(U_{CD}) = atan2\left(\frac{imag(U_{CD})}{real(U_{CD})}\right)$$

- rotating in a counterclockwise direction the system formed by the line-to-line voltages by the angle α calculated above:

$$U_{RS}' = |U_{RS}|e^{j[angle(U_{RS})-\alpha]}$$
$$U_{ST}' = |U_{ST}|e^{j[angle(U_{ST})-\alpha]}$$
$$U_{TR}' = |U_{TR}|e^{j[angle(U_{TR})-\alpha]}$$

- calculating the symmetrical components of the rotated line-to-line voltage system:

$$\begin{bmatrix} U_{CD}' \\ U_{CI}' \\ U_{CH}' \end{bmatrix} = \frac{1}{3}\begin{bmatrix} 1 & a & a^2 \\ 1 & a^2 & a \\ 1 & 1 & 1 \end{bmatrix}\begin{bmatrix} U_{RS}' \\ U_{ST}' \\ U_{TR}' \end{bmatrix}$$

- obtaining the line-to-neutral voltages:

$$\begin{bmatrix} U_R' \\ U_S' \\ U_T' \end{bmatrix} = \begin{bmatrix} 1 & 1 & 1 \\ a^2 & a & 1 \\ a & a^2 & 1 \end{bmatrix}\begin{bmatrix} U_D' \\ U_I' \\ U_H' \end{bmatrix}$$ taking into account the properties:

$$U_D' = U_{CD}'\varepsilon^{-1}$$

$$U_I' = U_{CI}'\varepsilon^{*-1}$$

$$U_H' = U_I'^*$$

where:

$$\varepsilon = -\frac{1}{2}\left(3 + j\sqrt{3}\right); \ \varepsilon^* = -\frac{1}{2}\left(3 - j\sqrt{3}\right).$$

- rotating in a clockwise direction the system formed by the line-to-line voltages by the angle $\alpha$ calculated above:

  $\circ$ $U_R = |U_R'|e^{j[angle(U_R')-\alpha]}$

  $\circ$ $U_S = |U_S'|e^{j[angle(U_S')-\alpha]}$

  $\circ$ $U_T = |U_T'|e^{j[angle(U_T')-\alpha]}$

**Claims**

1. A method of electrical balancing in a three-phase system **characterized in that** it comprises:

   i) obtaining (31) the magnitude and phase of each line-to-neutral output voltage (R,S,T) of the three-phase system forming a line-to-neutral voltage system ($U_R$, $U_S$, $U_T$);
   ii) aligning (32) a first line-to-neutral voltage with the real axis ($U_R$);
   iii) choosing (33) the first line-to-neutral voltage ($U_R$) previously aligned with the real axis and a second line-to-neutral voltage ($U_S$) selected from between the two remaining line-to-neutral voltages ($U_S$, $U_T$); and, adding a third line-to-neutral voltage ($U_S^*$) which is the complex conjugate of the greater ($U_S$) of the two previous line-to-neutral voltages ($U_S$, $U_T$);
   iv) calculating (34) the positive sequence voltage ($U_D$), the negative sequence voltage ($U_I$) and the zero sequence voltage ($U_H$) of the line-to-neutral voltage system formed by the first line-to-neutral voltage, the second line-to-neutral voltage and the third line-to-neutral voltage ($U_R$, $U_S$, $U_S^*$);
   v) adding (35) the negative value of the negative sequence voltage ($-U_I$) with respect to the previously calculated negative sequence voltage ($U_I$), by means of rotation at an angle "$\alpha$" of the phase of the second line-to-neutral voltage ($U_S$) and by means of rotation in the direction opposite to the previous direction of the phase of the third line-to-neutral voltage ($U_S^*$); thus obtaining a new line-to-neutral voltage system ($U_R$, $U_S$', $U_S^*$') formed by the first line-to-neutral voltage ($U_R$), a new second line-to-neutral voltage ($U_S$') equal in module to the second line-to-neutral voltage ($U_S$) but separated by an angle "$\alpha$" and a new third line-to-neutral voltage ($U_S^*$') equal in module to the third line-to-neutral voltage but counter-separated by a phase angle "$\alpha$";
   vi) calculating (36) the positive sequence voltage ($U_D$') and the zero sequence voltage ($U_H$') of the new line-to-neutral voltage system ($U_R$, $U_S$', $U_S^*$');
   vii) adding (37) the positive sequence voltage (SD) and zero sequence voltage (SH), respectively, to the positive sequence voltage ($U_D$') and to the zero sequence voltage ($U_H$') previously calculated by rotating the first line-to-neutral voltage ($U_R$) by an angle "$\beta$" and rotating the new second line-to-neutral voltage ($U_S$') by the same angle "$\beta$" in the opposite direction; thus obtaining a new positive sequence voltage ($U_D$") and a new zero sequence voltage ($U_H$");
   viii) calculating (38) the new line-to-neutral voltages ($U_R$", $U_S$", $U_T$") from the new positive sequence voltage ($U_D$") and the new zero sequence voltage ($U_H$"), with negative sequence voltage equal to zero;
   ix) repeating (39) steps vii) and viii) until the module of the new third line-to-neutral voltage ($U_T$") is equal to the module of the line-to-neutral output voltage discarded in step iii) ($U_T$); where the value of the angle "$\beta$" is modified in each iteration as a function of the difference between the modules of the previous voltages ($|U_T$"$| - |U_T|$·

2. The method according to claim 1, **characterized in that** the positive sequence voltage ($U_D$), the negative sequence voltage ($U_I$) and the zero sequence voltage ($U_H$) of a line-to-neutral voltage system ($U_R$, $U_S$, $U_T$) are calculated in the following way:

   • $U_D = \frac{1}{3}\left(U_R + U_S a + U_T a^2\right)$

   • $U_I = \frac{1}{3}\left(U_R + U_S a^2 + U_T a\right)$

$$U_H = \frac{1}{3}(U_R + U_S + U_T)$$

where $a = e^{j\frac{2\pi}{3}}$.

3. The method according to claim 1, **characterized in that** the first line-to-neutral voltage ($U_R$), the new second line-to-neutral voltage ($U_S$'), the new third line-to-neutral voltage ($U_S$*') and the angle "α" are related as follows:

$$(U_S' \cos(\alpha) + U_R)\tan\left(\frac{\pi}{6}\right) = U_S' \sin(\alpha)$$

$$U_S^{*\prime} = conj(U_S')$$

4. The method according to claim 1, **characterized in that** a first line-to-neutral voltage ($U_R$), a second line-to-neutral voltage ($U_S$) and a third line-to-neutral voltage ($U_T$) are obtained from positive sequence voltages ($U_D$), negative sequence voltages ($U_I$) and zero sequence voltages ($U_H$):

$$\begin{bmatrix} U_R \\ U_S \\ U_T \end{bmatrix} = \begin{bmatrix} 1 & 1 & 1 \\ a^2 & a & 1 \\ a & a^2 & 1 \end{bmatrix} \begin{bmatrix} U_D \\ U_I \\ U_H \end{bmatrix}$$

where $a = e^{j\frac{2\pi}{3}}$.

5. The method according to claim 1, **characterized in that** the positive sequence voltage (SD) and the zero sequence voltage (SH) that are added in step vii) are calculated in the following way:

$$U_R + SD_R + SH_R = U_R''$$

$$U_S' + SD_S + SH_S = U_S''$$

where:

$$SD_R = SD_{RX} + jSD_{RY}$$

$$SH_R = SH_S = SH = SH_X + jSH_Y$$

and,

$$\begin{pmatrix} SD_{RX} \\ SD_{RY} \\ SH_X \\ SH_Y \end{pmatrix} = \begin{pmatrix} 1 & 0 & 1 & 0 \\ 0 & 1 & 0 & 1 \\ \cos\left(\frac{4\pi}{3}\right) & \sin\left(\frac{4\pi}{3}\right) & 1 & 0 \\ -\sin\left(\frac{4\pi}{3}\right) & \cos\left(\frac{4\pi}{3}\right) & 0 & 1 \end{pmatrix}^{-1} \begin{pmatrix} -1 & 0 & 0 & 0 & 1 & 0 & 0 & 0 \\ 0 & -1 & 0 & 0 & 0 & 1 & 0 & 0 \\ 0 & 0 & -1 & 0 & 0 & 0 & 1 & 0 \\ 0 & 0 & 0 & -1 & 0 & 0 & 0 & 1 \end{pmatrix} \begin{pmatrix} real(U_R) \\ imag(U_R) \\ real(U_S') \\ imag(U_S') \\ real(U_R'') \\ imag(U_R'') \\ real(U_S'') \\ imag(U_S'') \end{pmatrix}$$

where

$$\begin{pmatrix} 1 & 0 & 1 & 0 \\ 0 & 1 & 0 & 1 \\ \cos\left(\frac{4\pi}{3}\right) & \sin\left(\frac{4\pi}{3}\right) & 1 & 0 \\ -\sin\left(\frac{4\pi}{3}\right) & \cos\left(\frac{4\pi}{3}\right) & 0 & 1 \end{pmatrix}^{-1} = \begin{pmatrix} -\cos\left(\frac{4\pi}{3}\right) & -\frac{1}{3}\sin\left(\frac{4\pi}{3}\right) & \cos\left(\frac{4\pi}{3}\right) & \frac{1}{3}\sin\left(\frac{4\pi}{3}\right) \\ \frac{1}{3}\sin\left(\frac{4\pi}{3}\right) & -\cos\left(\frac{4\pi}{3}\right) & -\frac{1}{3}\sin\left(\frac{4\pi}{3}\right) & \cos\left(\frac{4\pi}{3}\right) \\ -\cos\left(\frac{4\pi}{3}\right) & \frac{1}{3}\sin\left(\frac{4\pi}{3}\right) & -\cos\left(\frac{4\pi}{3}\right) & -\frac{1}{3}\sin\left(\frac{4\pi}{3}\right) \\ -\frac{1}{3}\sin\left(\frac{4\pi}{3}\right) & -\cos\left(\frac{4\pi}{3}\right) & \frac{1}{3}\sin\left(\frac{4\pi}{3}\right) & -\cos\left(\frac{4\pi}{3}\right) \end{pmatrix}$$

6. The method according to claim 1, **characterized in that** it further comprises calculating line-to-line voltages ($U_{RS}$, $U_{ST}$, $U_{TR}$) from the line-to-neutral voltages ($U_R$, $U_S$, $U_T$) by means of subtracting the two line-to-neutral voltages:

$$U_{RS} = U_S - U_R;$$

$$U_{ST} = U_T - U_S;$$

$$U_{TR} = U_R - U_T;$$

7. The method according to claim 1, **characterized in that** it further comprises calculating line-to-neutral voltages ($U_R$, $U_S$, $U_T$) from the line-to-line voltages ($U_{RS}$, $U_{ST}$, $U_{TR}$) by means of the following sub-steps:

• calculating the line-to-line voltage system ($U_{CD}$, $U_{CI}$, $U_{CH}$) formed by the positive sequence line-to-line voltage ($U_{CD}$), the negative sequence line-to-line voltage ($U_{CI}$) and the zero sequence line-to-line voltage ($U_{CH}$), associated with the line-to-line voltages ($U_{RS}$, $U_{ST}$, $U_{TR}$):

$$\begin{bmatrix} U_{CD} \\ U_{CI} \\ U_{CH} \end{bmatrix} = \frac{1}{3}\begin{bmatrix} 1 & a & a^2 \\ 1 & a^2 & a \\ 1 & 1 & 1 \end{bmatrix}\begin{bmatrix} U_{RS} \\ U_{ST} \\ U_{TR} \end{bmatrix}$$

where $a = e^{j\frac{2\pi}{3}}$

• calculating the angle "α" of the positive sequence and subtract $\pi/6$:

$$\alpha = angle(U_{CD}) - \frac{\pi}{6}$$

$$angle(U_{CD}) = atan2\left(\frac{imag(U_{CD})}{real(U_{CD})}\right)$$

where:

• rotating in a counterclockwise direction the system formed by the line-to-line voltages by the angle α calculated above:

$$U'_{RS} = |U_{RS}|e^{j[angle(U_{RS})-\alpha]}$$

$$U'_{ST} = |U_{ST}|e^{j[angle(U_{ST})-\alpha]}$$

$$U'_{TR} = |U_{TR}|e^{j[angle(U_{TR})-\alpha]}$$

• calculating the positive sequence line-to-line voltage ($U'_{CD}$), the negative sequence line-to-line voltage ($U'_{CI}$) and the zero sequence line-to-line voltage ($U'_{CI}$) of the rotated line-to-line voltage system:

$$\begin{bmatrix} U'_{CD} \\ U'_{CI} \\ U'_{CH} \end{bmatrix} = \frac{1}{3} \begin{bmatrix} 1 & a & a^2 \\ 1 & a^2 & a \\ 1 & 1 & 1 \end{bmatrix} \begin{bmatrix} U'_{RS} \\ U'_{ST} \\ U'_{TR} \end{bmatrix}$$

• obtaining the system formed by the line-to-neutral voltages ($U'_R$, $U'_S$, $U'_T$) from the line-to-line voltage system ($U'_D$, $U'_I$, $U'_H$):

$$\begin{bmatrix} U'_R \\ U'_S \\ U'_T \end{bmatrix} = \begin{bmatrix} 1 & 1 & 1 \\ a^2 & a & 1 \\ a & a^2 & 1 \end{bmatrix} \begin{bmatrix} U'_D \\ U'_I \\ U'_H \end{bmatrix}$$

taking into account the properties:

$$U'_D = U'_{CD}\varepsilon^{-1}$$

$$U'_I = U'_{CI}\varepsilon^{*-1}$$

$$U'_H = U'^{*}_I$$

where:

$$\varepsilon = -\frac{1}{2}\left(3 + j\sqrt{3}\right); \ \varepsilon^* = -\frac{1}{2}\left(3 - j\sqrt{3}\right);$$

• rotating in a clockwise direction the system formed by the line-to-neutral voltages by the angle $\alpha$ calculated above:

$$U_R = |U'_R|e^{j[angle(U'_R)-\alpha]}$$

$$U_S = |U'_S|e^{j[angle(U'_S)-\alpha]}$$

$$U_T = |U'_T|e^{j[angle(U'_T)-\alpha]}$$

8. A three-phase system, **characterized in that** it comprises:

   • a three-phase power outlet (R,S,T);
   • power cells (3) connected in cascade by each power line;
   • a control card (4) for each power cell (3), the control card is configured to measure the voltage supplied by the cell with which it is associated and to modify the voltage of the power cell;
   • control equipment (6) connected to each control card (4) and to the three-phase power outlet (R,S,T) to obtain the magnitude and phase of each line-to-neutral voltage ($U_R$, Us, $U_T$);

   the control equipment (6) having means configured to carry out the method of electrical balancing defined in claims 1 to 7, modifies the magnitude and phase of the voltage of each cell by means of each control card until the three-phase system output reaches the new line-to-neutral voltages ($U_R''$, $U_S''$, $U_T''$).

9. The system according to claim 8, **characterized in that** the power cell (3) further comprises a bypass circuit (5), where the bypass circuit is closed when the bypass circuit receives a closing command from the control card (4).

**Patentansprüche**

1. Verfahren zum elektrischen Ausgleichen in einem Dreiphasensystem, **dadurch gekennzeichnet, dass** das Verfahren umfasst:

   i) Erhalten (31) der Größe und der Phase jeder Leiter-Neutralleiter-Ausgangsspannung (R, S, T) des Dreiphasensystems, das ein Leiter-Neutralleiter-Spannungssystem ($U_R$, $U_S$, $U_T$) bildet;
   ii) Ausrichten (32) einer ersten Leiter-Neutralleiter-Spannung zu der reellen Achse ($U_R$);
   iii) Auswählen (33) der ersten Leiter-Neutralleiter-Spannung ($U_R$), die zuvor zu der reellen Achse ausgerichtet wurde, und einer zweiten Leiter-Neutralleiter-Spannung ($U_S$), die aus den zwei verbliebenen Leiter-Neutralleiter-Spannungen ($U_S$, $U_T$) ausgewählt ist; und Hinzufügen einer dritten Leiter-Neutralleiter-Spannung ($U_S$*), die das komplex Konjugierte der größeren Spannung ($U_S$) der beiden vorhergehenden Leiter-Neutralleiter-Spannungen ($U_S$, $U_T$) ist;
   iv) Berechnen (34) der positiven Abschnittsspannung ($U_D$), der negativen Abschnittsspannung ($U_I$) und der Null-Abschnittsspannung ($U_H$) des Leiter-Neutralleiter-Spannungssystems, das durch die erste Leiter-Neutralleiter-Spannung, die zweite Leiter-Neutralleiter-Spannung und die dritte Leiter-Neutralleiter-Spannung ($U_R$, $U_S$, $U_S$*) gebildet ist;
   v) Addieren (35) des negativen Wertes der negativen Abschnittsspannung ($-U_I$) in Bezug auf die zuvor berechnete negative Abschnittsspannung ($U_I$) mittels einer Drehung der Phase der zweiten Leiter-Neutralleiter-Spannung ($U_S$) um einen Winkel "α" und mittels einer Drehung der Phase der dritten Leiter-Neutralleiter-Spannung ($U_S$*) in der entgegengesetzten Richtung zu der vorhergehenden Richtung, so dass ein neues Leiter-Neutralleiter-Spannungssystem ($U_R$, $U_S$', $U_S$*') erhalten wird, das durch die erste Leiter-Neutralleiter-Spannung ($U_R$), eine neue zweite Leiter-Neutralleiter-Spannung ($U_S$'), deren Modul gleich demjenigen der zweiten Leiter-Neutralleiter-Spannung ($U_S$) ist, aber durch einen Winkel "α" davon getrennt ist, und eine neue dritte Leiter-Neutralleiter-Spannung ($U_S$*'), deren Modul gleich demjenigen der dritten Leiter-Neutralleiter-Spannung ist, aber in Gegenrichtung davon durch einen Phasenwinkel "α" getrennt ist, gebildet ist;
   vi) Berechnen (36) der positiven Abschnittsspannung ($U_D$') und der Null-Abschnittsspannung ($U_H$') des neuen Leiter-Neutralleiter-Spannungssystems ($U_R$, $U_S$', $U_S$*');
   vii) Addieren (37) der positiven Abschnittsspannung (SD) und der Null-Abschnittsspannung (SH) entsprechend zu der positiven Abschnittsspannung ($U_D$') und der Null-Abschnittsspannung ($U_H$'), die zuvor berechnet wurden, durch Drehen der ersten Leiter-Neutralleiter-Spannung ($U_R$) um einen Winkel "β" und durch Drehen der neuen zweiten Leiter-Neutralleiter-Spannung ($U_S$') um den gleichen Winkel "β" in der entgegengesetzten Richtung, wodurch eine neue positive Abschnittsspannung ($U_D$") und eine neue Null-Abschnittsspannung ($U_H$") erhalten werden;
   viii) Berechnen (38) der neuen Leiter-Neutralleiter-Spannungen ($U_R$", $U_S$", $U_T$") aus der neuen positiven Abschnittsspannung ($U_D$") und der neuen Null-Abschnittsspannung ($U_H$"), wobei die negative Abschnittsspannung gleich Null ist;
   ix) Wiederholen (39) der Schritte vii) und viii), bis der Modul der neuen dritten Leiter-Neutralleiter-Spannung ($U_T$") gleich dem Modul der Leiter-Neutralleiter-Außenspannung ist, die im Schritt iii) ($U_T$) verworfen wurde, wobei der Wert des Winkels "β" bei jedem Schritt als Funktion der Differenz zwischen den Modulen der vorhergehenden Spannungen ($|U_T"| - |U_T|$) modifiziert wird.

2. Verfahren nach Anspruch 1, **dadurch gekennzeichnet, dass** die positive Abschnittsspannung ($U_D$), die negative Abschnittsspannung ($U_I$) und die Null-Abschnittsspannung ($U_H$) eines Leiter-Neutralleiter-Spannungssystems ($U_R$, $U_S$, $U_T$) in der folgenden Weise berechnet werden:

$$\bullet \quad U_D = \frac{1}{3}(U_R + U_S a + U_T a^2)$$
$$\bullet \quad U_I = \frac{1}{3}(U_R + U_S a^2 + U_T a)$$
$$\bullet \quad U_H = \frac{1}{3}(U_R + U_S + U_T)$$

wobei $a = e^{j\frac{2\pi}{3}}$.

3. Verfahren nach Anspruch 1, **dadurch gekennzeichnet, dass** die erste Leiter-Neutralleiter-Spannung ($U_R$), die neue zweite Leiter-Neutralleiter-Spannung ($U_S$'), die neue dritte Leiter-Neutralleiter-Spannung ($U_S$*') und der Winkel "α" wie folgt miteinander in Beziehung stehen:

$$(U'_S \cos(\alpha) + U_R) \tan\left(\frac{\pi}{6}\right) = U'_S \sin(\alpha)$$

$$U^{*'}_S = conj(U'_S)$$

4. Verfahren nach Anspruch 1, **dadurch gekennzeichnet, dass** eine erste Leiter-Neutralleiter-Spannung ($U_R$), eine zweite Leiter-Neutralleiter-Spannung ($U_S$) und eine dritte Leiter-Neutralleiter-Spannung ($U_T$) aus positiven Abschnittsspannungen ($U_D$), negativen Abschnittspannungen ($U_I$) und Null-Abschnittsspannungen ($U_H$) erhalten werden durch:

$$\begin{bmatrix} U_R \\ U_S \\ U_T \end{bmatrix} = \begin{bmatrix} 1 & 1 & 1 \\ a^2 & a & 1 \\ a & a^2 & 1 \end{bmatrix} \begin{bmatrix} U_D \\ U_I \\ U_H \end{bmatrix}$$

wobei $a = e^{j\frac{2\pi}{3}}$.

5. Verfahren nach Anspruch 1, **dadurch gekennzeichnet, dass** die positive Abschnittsspannung (SD) und die Null-Abschnittsspannung (SH), die im Schritt vii) addiert werden, in der folgenden Weise berechnet werden:

$$U_R + SD_R + SH_R = U''_R$$

$$U'_S + SD_S + SH_S = U''_S$$

wobei:

$$SD_R = SD_{RX} + jSD_{RY}$$

$$SH_R = SH_S = SH = SH_X + jSH_Y$$

und

$$\begin{pmatrix} SD_{RX} \\ SD_{RY} \\ SH_X \\ SH_Y \end{pmatrix} = \begin{pmatrix} 1 & 0 & 1 & 0 \\ 0 & 1 & 0 & 1 \\ \cos\left(\frac{4\pi}{3}\right) & \sin\left(\frac{4\pi}{3}\right) & 1 & 0 \\ -\sin\left(\frac{4\pi}{3}\right) & \cos\left(\frac{4\pi}{3}\right) & 0 & 1 \end{pmatrix}^{-1} \begin{pmatrix} -1 & 0 & 0 & 0 & 1 & 0 & 0 & 0 \\ 0 & -1 & 0 & 0 & 0 & 1 & 0 & 0 \\ 0 & 0 & -1 & 0 & 0 & 0 & 1 & 0 \\ 0 & 0 & 0 & -1 & 0 & 0 & 0 & 1 \end{pmatrix} \begin{pmatrix} real(U_R) \\ imag(U_R) \\ real(U'_S) \\ imag(U'_S) \\ real(U''_R) \\ imag(U''_R) \\ real(U''_S) \\ imag(U''_S) \end{pmatrix}$$

wobei

$$\begin{pmatrix} 1 & 0 & 1 & 0 \\ 0 & 1 & 0 & 1 \\ \cos\left(\frac{4\pi}{3}\right) & \sin\left(\frac{4\pi}{3}\right) & 1 & 0 \\ -\sin\left(\frac{4\pi}{3}\right) & \cos\left(\frac{4\pi}{3}\right) & 0 & 1 \end{pmatrix}^{-1} = \begin{pmatrix} -\cos\left(\frac{4\pi}{3}\right) & -\frac{1}{3}\sin\left(\frac{4\pi}{3}\right) & \cos\left(\frac{4\pi}{3}\right) & \frac{1}{3}\sin\left(\frac{4\pi}{3}\right) \\ \frac{1}{3}\sin\left(\frac{4\pi}{3}\right) & -\cos\left(\frac{4\pi}{3}\right) & -\frac{1}{3}\sin\left(\frac{4\pi}{3}\right) & \cos\left(\frac{4\pi}{3}\right) \\ -\cos\left(\frac{4\pi}{3}\right) & \frac{1}{3}\sin\left(\frac{4\pi}{3}\right) & -\cos\left(\frac{4\pi}{3}\right) & -\frac{1}{3}\sin\left(\frac{4\pi}{3}\right) \\ -\frac{1}{3}\sin\left(\frac{4\pi}{3}\right) & -\cos\left(\frac{4\pi}{3}\right) & \frac{1}{3}\sin\left(\frac{4\pi}{3}\right) & -\cos\left(\frac{4\pi}{3}\right) \end{pmatrix}$$

gilt.

6. Verfahren nach Anspruch 1, **dadurch gekennzeichnet, dass** das Verfahren ferner umfasst: Berechnen von Leiter-Leiter-Spannungen ($U_{RS}$, $U_{ST}$, $U_{TR}$) aus den Leiter-Neutralleiter-Spannungen ($U_R$, $U_S$, $U_T$) durch Subtrahieren der beiden Leiter-Neutralleiter-Spannungen:

$$U_{RS} = U_S - U_R;$$

$$U_{ST} = U_T - U_S;$$

$$U_{TR} = U_R - U_T;$$

7. Verfahren nach Anspruch 1, **dadurch gekennzeichnet, dass** das Verfahren ferner umfasst: Berechnen von Leiter-Neutralleiter-Spannungen ($U_R$, $U_S$, $U_T$) aus den Leiter-Leiter-Spannungen ($U_{RS}$, $U_{ST}$, $U_{TR}$) durch die folgenden Teilschritte:

• Berechnen des Leiter-Leiter-Spannungssystems ($U_{CD}$, $U_{CI}$, $U_{CH}$), das durch die positive Abschnitts-Leiter-Leiter-Spannung ($U_{CD}$), die negative Abschnitts-Leiter-Leiter-Spannung ($U_{CI}$) und die Null-Abschnitts-Leiter-Leiter-Spannung ($U_{CH}$) gebildet ist, die mit den Leiter-Leiter-Spannungen ($U_{RS}$, $U_{ST}$, $U_{TR}$) verknüpft sind durch:

$$\begin{bmatrix} U_{CD} \\ U_{CI} \\ U_{CH} \end{bmatrix} = \frac{1}{3}\begin{bmatrix} 1 & a & a^2 \\ 1 & a^2 & a \\ 1 & 1 & 1 \end{bmatrix}\begin{bmatrix} U_{RS} \\ U_{ST} \\ U_{TR} \end{bmatrix}$$

wobei $a = e^{j\frac{2\pi}{3}}$ ;

• Berechnen des Winkels "$\alpha$" des positiven Abschnitts und Subtrahieren von $\pi/6$:

$$\alpha = angle(U_{CD}) - \frac{\pi}{6}$$

$$angle(U_{CD}) = atan2\left(\frac{imag(U_{CD})}{real(U_{CD})}\right) ;$$

wobei:

• Drehen des Systems, das durch die Leiter-Leiter-Spannungen gebildet ist, um den Winkel $\alpha$, der zuvor berechnet ist, im Gegenuhrzeigersinn:

$\circ\ U'_{RS} = |U_{RS}|e^{j[angle(U_{RS})-\alpha]}$

$\circ\ U'_{ST} = |U_{ST}|e^{j[angle(U_{ST})-\alpha]}$

$\circ\ U'_{TR} = |U_{TR}|e^{j[angle(U_{TR})-\alpha]}$

• Berechnen der positiven Abschnitts-Leiter-Leiter-Spannung ($U'_{CD}$), der negativen Abschnitts-Leiter-Leiter-Spannung ($U'_{CI}$) und der Null-Abschnitts-Leiter-Leiter-Spannung ($U'_{CI}$) des gedrehten Leiter-Leiter-Spannungssystems:

$$\begin{bmatrix} U'_{CD} \\ U'_{CI} \\ U'_{CH} \end{bmatrix} = \frac{1}{3}\begin{bmatrix} 1 & a & a^2 \\ 1 & a^2 & a \\ 1 & 1 & 1 \end{bmatrix}\begin{bmatrix} U'_{RS} \\ U'_{ST} \\ U'_{TR} \end{bmatrix}$$

• Erhalten des Systems, das durch die Leiter-Neutralleiter-Spannungen ($U'_R$, $U'_S$, $U'_T$) gebildet ist, aus dem Leiter-Leiter-Spannungssystem ($U'_D$, $U'_I$, $U'_H$):

$$\begin{bmatrix} U'_R \\ U'_S \\ U'_T \end{bmatrix} = \begin{bmatrix} 1 & 1 & 1 \\ a^2 & a & 1 \\ a & a^2 & 1 \end{bmatrix}\begin{bmatrix} U'_D \\ U'_I \\ U'_H \end{bmatrix}$$

wobei die Eigenschaften berücksichtigt sind:

$$U'_D = U'_{CD}\varepsilon^{-1}$$

$$U'_I = U'_{CI}\varepsilon^{*-1}$$

$$U'_H = U'^{*}_I$$

wobei:

$$\varepsilon = -\frac{1}{2}\left(3 + j\sqrt{3}\right); \; \varepsilon^* = -\frac{1}{2}\left(3 - j\sqrt{3}\right);$$

• Drehen des Systems, das durch die Leiter-Neutralleiter-Spannungen gebildet ist, um den zuvor berechneten Winkel $\alpha$ im Uhrzeigersinn:

$$U_R = |U'_R|e^{j[angle(U'_R)-\alpha]}$$

$$U_S = |U'_S|e^{j[angle(U'_S)-\alpha]}$$

$$U_T = |U'_T|e^{j[angle(U'_T)-\alpha]}$$

8. Dreiphasensystem, **dadurch gekennzeichnet, dass** es aufweist:

• einen Dreiphasenleistungsausgang (R, S, T);
• Leistungszellen (3), die durch jede Leistungsleitung in Kaskade verbunden sind;
• eine Steuerkarte (4) für jede Leistungszelle (3), wobei die Steuerkarte ausgebildet ist, die Spannung zu messen, die von der Zelle geliefert wird, die ihr zugeordnet ist, und die Spannung der Leistungszelle zu ändern;
• eine Steuereinrichtung (6), die mit jeder Steuerkarte (4) und mit dem Dreiphasenleistungsausgang (R, S, T) verbunden ist, um die Größe und die Phase jeder Leiter-Neutralleiter-Spannung ($U_R$, $U_S$, $U_T$) zu erhalten;

wobei die Steuereinrichtung (6) eine Einrichtung aufweist, die ausgebildet ist, das Verfahren zum elektrischen Ausgleichen, das in den Ansprüchen 1 bis 7 angegeben ist, auszuführen, und die Größe und die Phase der Spannung jeder Zelle mittels jeder Steuerkarte zu ändern, bis der Dreiphasensystemausgang die neuen Leiter-Neutralleiter-Spannungen ($U_R$", $U_S$", $U_T$") erreicht.

9. System nach Anspruch 8, **dadurch gekennzeichnet, dass** die Leistungszelle (3) ferner eine Umgehungsschaltung (5) aufweist, wobei die Umgehungsschaltung geschlossen ist, wenn die Umgehungsschaltung einen Schließbefehl aus der Steuerkarte (4) erhält.

**Revendications**

1. Procédé d'équilibrage électrique dans un système triphasé **caractérisé en ce qu'**il consiste à :

> i) obtenir (31) l'amplitude et la phase de chaque tension de sortie phase-neutre (R, S, T) du système triphasé formant un système de tensions phase-neutre ($U_R$, $U_S$, $U_T$) ;
> ii) aligner (32) une première tension phase-neutre avec l'axe réel ($U_R$) ;
> iii) choisir (33) la première tension phase-neutre ($U_R$) précédemment alignée avec l'axe réel et une deuxième tension phase-neutre ($U_S$) sélectionnée parmi les deux tensions phase-neutre restantes ($U_S$, $U_T$) ; et ajouter une troisième tension phase-neutre ($U_S$*) qui est le conjugué complexe de la plus grande ($U_S$) des deux tensions phase-neutre précédentes ($U_S$, $U_T$) ;
> iv) calculer (34) la tension de séquence positive ($U_D$), la tension de séquence négative ($U_I$) et la tension homopolaire ($U_H$) du système de tensions phase-neutre formé par la première tension phase-neutre, la deuxième tension phase-neutre et la troisième tension phase-neutre ($U_R$, $U_S$, $U_S$*) ;
> v) additionner (35) la valeur négative de la tension de séquence négative (-$U_I$) par rapport à la tension de séquence négative précédemment calculée ($U_I$), au moyen d'une rotation à un angle « $\alpha$ » de la phase de la deuxième tension phase-neutre ($U_S$) et au moyen d'une rotation dans le sens opposé au sens précédent de la phase de la troisième tension phase-neutre ($U_S$*) ; en obtenant ainsi un nouveau système de tensions phase-neutre ($U_R$, $U_S$', $U_S$*') formé par la première tension phase-neutre ($U_R$), une nouvelle deuxième tension phase-neutre ($U_S$') égale en module à la deuxième tension phase-neutre ($U_S$) mais séparées par un angle « $\alpha$ » et une nouvelle troisième tension phase-neutre ($U_S$*') égale en module à la troisième tension phase-neutre mais contre-séparées par un angle de phase « $\alpha$ » ;
> vi) calculer (36) la tension de séquence positive ($U_D$') et la tension homopolaire ($U_H$') du nouveau système de tensions phase-neutre ($U_R$, $U_S$', $U_S$*') ;
> vii) additionner (37) la tension de séquence positive (SD) et la tension homopolaire (SH), respectivement, à la tension de séquence positive ($U_D$') et à la tension homopolaire ($U_H$') précédemment calculées par la rotation de la première tension phase-neutre ($U_R$) par un angle « $\beta$ » et la rotation de la deuxième seconde tension phase-neutre ($U_S$') par un même angle « $\beta$ » dans le sens opposé ; en obtenant ainsi une nouvelle tension de séquence positive ($U_D$") et une nouvelle tension homopolaire ($U_H$") ;
> viii) calculer (38) les nouvelles tensions phase-neutre ($U_R$", $U_S$", $U_T$") à partir de la nouvelle tension de séquence positive ($U_D$") et de la nouvelle tension homopolaire ($U_H$"), avec une tension de séquence négative égale à zéro ;
> ix) répéter (39) les étapes vii) et viii) jusqu'à ce que le module de la nouvelle troisième tension phase-neutre ($U_T$") soit égal au module de la tension de sortie phase-neutre rejetée à l'étape iii) ($U_T$) ; dans lequel la valeur de l'angle « $\beta$ » est modifiée dans chaque itération en fonction de la différence entre les modules des tensions précédentes ($|U_T$"| - $|U_T|$).

2. Procédé selon la revendication 1, **caractérisé en ce que** la tension de séquence positive ($U_D$), la tension de séquence négative ($U_I$) et la tension homopolaire ($U_H$) d'un système de tensions phase-neutre ($U_R$, $U_S$, $U_T$) sont calculées de la manière suivante :

$$U_D = \frac{1}{3}(U_R + U_S a + U_T a^2)$$

$$U_I = \frac{1}{3}(U_R + U_S a^2 + U_T a)$$

$$U_H = \frac{1}{3}(U_R + U_S + U_T)$$

où $a = e^{j\frac{2\pi}{3}}$.

3. Procédé selon la revendication 1, **caractérisé en ce que** la première tension phase-neutre ($U_R$), la nouvelle deuxième tension phase-neutre ($U_S$'), la nouvelle troisième tension phase-neutre ($U_S^*$') et les angles « $\alpha$ » sont désignés comme suit :

$$(U_S' \cos(\alpha) + U_R) \tan\left(\frac{\pi}{6}\right) = U_S' \sin(\alpha)$$

$$U_S^{*\prime} = conj(U_S')$$

4. Procédé selon la revendication 1, **caractérisé en ce qu'**une première tension phase-neutre ($U_R$), une deuxième tension phase-neutre ($U_S$) et une troisième tension phase-neutre ($U_T$) sont obtenues à partir de tensions de séquence positive ($U_D$), de tensions de séquence négative ($U_I$) et de tensions homopolaires ($U_H$) :

$$\begin{bmatrix} U_R \\ U_S \\ U_T \end{bmatrix} = \begin{bmatrix} 1 & 1 & 1 \\ a^2 & a & 1 \\ a & a^2 & 1 \end{bmatrix} \begin{bmatrix} U_D \\ U_I \\ U_H \end{bmatrix}$$

où $a = e^{j\frac{2\pi}{3}}$.

5. Procédé selon la revendication 1, **caractérisé en ce que** la tension de séquence positive (SD) et la tension homopolaire (SH) qui sont additionnées à l'étape vii) sont calculées de la manière suivante :

$$U_R + SD_R + SH_R = U_R''$$

$$U_S' + SD_S + SH_S = U_S''$$

où :

$$SD_R = SD_{RX} + jSD_{RY}$$

$$SH_R = SH_S = SH = SH_X + jSH_Y$$

et,

$$\begin{pmatrix} SD_{RX} \\ SD_{RY} \\ SH_X \\ SH_Y \end{pmatrix} = \begin{pmatrix} 1 & 0 & 1 & 0 \\ 0 & 1 & 0 & 1 \\ \cos\left(\frac{4\pi}{3}\right) & \sin\left(\frac{4\pi}{3}\right) & 1 & 0 \\ -\sin\left(\frac{4\pi}{3}\right) & \cos\left(\frac{4\pi}{3}\right) & 0 & 1 \end{pmatrix}^{-1} \begin{pmatrix} -1 & 0 & 0 & 0 & 1 & 0 & 0 & 0 \\ 0 & -1 & 0 & 0 & 0 & 1 & 0 & 0 \\ 0 & 0 & -1 & 0 & 0 & 0 & 1 & 0 \\ 0 & 0 & 0 & -1 & 0 & 0 & 0 & 1 \end{pmatrix} \begin{pmatrix} real(U_R) \\ imag(U_R) \\ real(U_S') \\ imag(U_S') \\ real(U_R'') \\ imag(U_R'') \\ real(U_S'') \\ imag(U_S'') \end{pmatrix}$$

où

$$\begin{pmatrix} 1 & 0 & 1 & 0 \\ 0 & 1 & 0 & 1 \\ \cos\left(\dfrac{4\pi}{3}\right) & \sin\left(\dfrac{4\pi}{3}\right) & 1 & 0 \\ -\sin\left(\dfrac{4\pi}{3}\right) & \cos\left(\dfrac{4\pi}{3}\right) & 0 & 1 \end{pmatrix}^{-1} = \begin{pmatrix} -\cos\left(\dfrac{4\pi}{3}\right) & -\dfrac{1}{3}\sin\left(\dfrac{4\pi}{3}\right) & \cos\left(\dfrac{4\pi}{3}\right) & \dfrac{1}{3}\sin\left(\dfrac{4\pi}{3}\right) \\ \dfrac{1}{3}\sin\left(\dfrac{4\pi}{3}\right) & -\cos\left(\dfrac{4\pi}{3}\right) & -\dfrac{1}{3}\sin\left(\dfrac{4\pi}{3}\right) & \cos\left(\dfrac{4\pi}{3}\right) \\ -\cos\left(\dfrac{4\pi}{3}\right) & \dfrac{1}{3}\sin\left(\dfrac{4\pi}{3}\right) & -\cos\left(\dfrac{4\pi}{3}\right) & -\dfrac{1}{3}\sin\left(\dfrac{4\pi}{3}\right) \\ -\dfrac{1}{3}\sin\left(\dfrac{4\pi}{3}\right) & -\cos\left(\dfrac{4\pi}{3}\right) & \dfrac{1}{3}\sin\left(\dfrac{4\pi}{3}\right) & -\cos\left(\dfrac{4\pi}{3}\right) \end{pmatrix}$$

**6.** Procédé selon la revendication 1, **caractérisé en ce qu'**il consiste en outre à calculer des tensions phase-phase ($U_{RS}$, $U_{ST}$, $U_{TR}$) à partir des tensions phase-neutre ($U_R$, $U_S$, $U_T$) au moyen d'une soustraction des deux tensions phase-neutre :

$$U_{RS} = U_S - U_R \ ;$$

$$U_{ST} = U_T - U_S \ ;$$

$$U_{TR} = U_R - U_T \ ;$$

**7.** Procédé selon la revendication 1, **caractérisé en ce qu'**il consiste en outre à calculer des tensions phase-neutre ($U_R$, $U_S$, $U_T$) à partir des tensions phase-phase ($U_{RS}$, $U_{ST}$, $U_{TR}$) au moyen des sous-étapes suivantes :

• calculer le système de tensions phase-phase ($U_{CD}$, $U_{CI}$, $U_{CH}$) formé par la tension phase-phase de séquence positive ($U_{CD}$), la tension phase-phase de séquence négative ($U_{CI}$) et la tension phase-phase homopolaire ($U_{CH}$), associées aux tensions phase-phase ($U_{RS}$, $U_{ST}$, $U_{TR}$) :

$$\begin{bmatrix} U_{CD} \\ U_{CI} \\ U_{CH} \end{bmatrix} = \frac{1}{3}\begin{bmatrix} 1 & a & a^2 \\ 1 & a^2 & a \\ 1 & 1 & 1 \end{bmatrix}\begin{bmatrix} U_{RS} \\ U_{ST} \\ U_{TR} \end{bmatrix}$$

où $a = e^{j\frac{2\pi}{3}}$

• calculer l'angle « $\alpha$ » de la séquence positive et soustraire $\pi/6$ :

$$\alpha = angle(U_{CD}) - \frac{\pi}{6}$$

où : $angle(U_{CD}) = atan2\left(\frac{imag(U_{CD})}{real(U_{CD})}\right)$

• tourner dans le sens inverse des aiguilles d'une montre le système formé par les tensions phase-phase par l'angle $\alpha$ calculé ci-dessus :

$\circ\ U'_{RS} = |U_{RS}|e^{j[angle(U_{RS})-\alpha]}$

$\circ\ U'_{ST} = |U_{ST}|e^{j[angle(U_{ST})-\alpha]}$

$\circ\ U'_{TR} = |U_{TR}|e^{j[angle(U_{TR})-\alpha]}$

• calculer la tension phase-phase de séquence positive ($U'_{CD}$), la tension phase-phase de séquence négative ($U'_{CI}$) et la tension phase-phase homopolaire ($U'_{CI}$) du système de tensions phase-phase tourné :

$$\begin{bmatrix} U'_{CD} \\ U'_{CI} \\ U'_{CH} \end{bmatrix} = \frac{1}{3} \begin{bmatrix} 1 & a & a^2 \\ 1 & a^2 & a \\ 1 & 1 & 1 \end{bmatrix} \begin{bmatrix} U'_{RS} \\ U'_{ST} \\ U'_{TR} \end{bmatrix}$$

• obtenir le système formé par les tensions phase-neutre ($U'_R$, $U'_S$, $U'_T$) à partir du système de tensions phase-phase ($U'_D$, $U'_I$, $U'_H$) :

$$\begin{bmatrix} U'_{R} \\ U'_{S} \\ U'_{T} \end{bmatrix} = \begin{bmatrix} 1 & 1 & 1 \\ a^2 & a & 1 \\ a & a^2 & 1 \end{bmatrix} \begin{bmatrix} U'_{D} \\ U'_{I} \\ U'_{H} \end{bmatrix}$$

en tenant compte des propriétés :

$$U'_D = U'_{CD}\varepsilon^{-1}$$

$$U'_I = U'_{CI}\varepsilon^{*-1}$$

$$U'_H = U'^{*}_I$$

où :

$$\varepsilon = -\frac{1}{2}\left(3 + j\sqrt{3}\right); \ \varepsilon^* = -\frac{1}{2}\left(3 - j\sqrt{3}\right);$$

• tourner dans le sens des aiguilles d'une montre le système formé par les tensions phase-neutre par l'angle a calculé ci-dessus :

$$U_R = |U'_R|e^{j\left[angle(U'_R)-\alpha\right]}$$

$$U_S = |U'_S|e^{j\left[angle(U'_S)-\alpha\right]}$$

$$U_T = |U'_T|e^{j\left[angle(U'_T)-\alpha\right]}$$

8. Système triphasé, **caractérisé en ce qu'**il comprend :

    • une prise d'alimentation triphasée (R, S, T) ;
    • des cellules d'alimentation (3) connectées en cascade par chaque ligne d'alimentation ;
    • une carte de commande (4) pour chaque cellule d'alimentation (3), la carte de commande est configurée pour mesurer la tension fournie par la cellule avec laquelle elle est associée et pour modifier la tension de la cellule d'alimentation ;
    • un équipement de commande (6) connecté à chaque carte de commande (4) et à la prise d'alimentation triphasée (R, S, T) pour obtenir l'amplitude et la phase de chaque tension phase-neutre ($U_R$, $U_S$, $U_T$) ;

l'équipement de commande (6) ayant des moyens configurés pour mettre en oeuvre le procédé d'équilibrage électrique défini selon les revendications 1 à 7, modifie l'amplitude et la phase de la tension de chaque cellule au moyen de chaque carte de commande jusqu'à ce que la sortie du système triphasé atteigne les nouvelles tensions phase-neutre ($U_R''$, $U_S''$, $U_T''$).

**9.** Système selon la revendication 8, **caractérisé en ce que** la cellule d'alimentation (3) comprend en outre un circuit de dérivation (5), dans lequel le circuit de dérivation est fermé lorsque le circuit de dérivation reçoit une instruction de fermeture provenant de la carte de commande (4).

FIG. 1

FIG. 2

FIG. 3

FIG. 4

UNBALANCED
SYSTEM

ZERO
SEQUENCE

NEGATIVE
SEQUENCE

POSITIVE
SEQUENCE

# FIG. 5

$U_{ds}(t) = U_d \, Re \, (e^{j(wt-\frac{2\pi}{3})})$

$\vec{U_{ds}}$

$\vec{D}$

$\vec{U_{dr}}$

$U_{dr}(t) = U_d \, Re \, (e^{jwt})$

$\vec{U_{dt}}$

$U_{dt}(t) = U_d \, Re \, (e^{j(wt-\frac{4\pi}{3})})$

# FIG. 6

$U_{is}{}''(t) = U_i \, Re \, (e^{j(-wt-\frac{2\pi}{3})})$

$\overrightarrow{U_{is}{}''}$

$\overrightarrow{I}$

$\overrightarrow{U_{ir}{}''}$

$U_{ir}{}''(t) = U_i \, Re \, (e^{j-wt})$

$\overrightarrow{U_{it}{}''}$

$U_{it}{}''(t) = U_i \, Re \, (e^{j(-wt-\frac{4\pi}{3})})$

## FIG. 7

$U_{is}{}'(t) = U_i \, Re \, (e^{j(wt+\frac{2\pi}{3})})$

$\overrightarrow{U_{is}{}'}$

$\overrightarrow{I}$

$\overrightarrow{U_{ir}{}'}$

$U_{ir}{}'(t) = U_i \, Re \, (e^{jwt})$

$\overrightarrow{U_{it}{}'}$

$U_{it}{}'(t) = U_i \, Re \, (e^{j(wt+\frac{4\pi}{3})})$

## FIG. 8

34

$$U_{is}(t) = U_i \, Re \, (e^{\, j(wt-\frac{4\pi}{3})})$$

$$U_{ir}(t) = U_i \, Re \, (e^{\, jwt})$$

$$U_{it}(t) = U_i \, Re \, (e^{\, j(wt-\frac{2\pi}{3})})$$

**FIG. 9**

$$U_{hr}(t) = U_h \, Re \, (e^{\, jwt})$$
$$U_{hs}(t) = U_h \, Re \, (e^{\, jwt})$$
$$U_{ht}(t) = U_h \, Re \, (e^{\, jwt})$$

**FIG. 10**

FIG. 11

FIG. 12

FIG. 13

FIG. 14

FIG. 15

38

**EP 3 331 163 B1**

**Patent documents cited in the description**

- US 5986909 A1